# EUROPEAN PATENT APPLICATION

(11) **EP 4 553 894 A1**
(43) Date of publication of application: **14.05.2025**
(21) Application number: 24209399.5
(22) Date of filing: 29.10.2024
(51) Int. Cl.: H01L 23/373, H01L 23/473

(54) **STRUCTURE AND METHOD FOR OPTIMIZING THROUGH SUBSTRATE VIAS AND COOLING CHANNELS IN A COMPOSITE SUBSTRATE**

(30) Priority: 06.11.2023 US 202363596518 P; 23.04.2024 US 202418643267
(71) Applicant: Avago Technologies International Sales Pte. Limited, Singapore 768923 (SG)
(72) Inventor: THEIL, Jeremy Alfred, Irvine, 92618 (US)
(74) Representative: Dilg, Haeusler, Schindelmann Patentanwaltsgesellschaft mbH

(57) **Abstract**

Technical solutions present structures, systems and methods for providing a cold plate for thermal management of circuit dies (105) using cooling channels (250) and through surface vias (TSVs) formed through multiple bonded substrates. A first substrate (260) can include a circuit (210) coupled with first electrical contacts etched in the first substrate (260) and a second substrate (265) can include second electrical contacts etched in the second substrate (265). A channel (250) can be etched between the second electrical contacts. A third substrate (270) can include third electrical contacts etched to form combined channel (290) enclosed by the first substrate (260), the second substrate (265) and the third substrate (270). The circuit (210) can be electrically coupled with the third plurality of electrical contacts via the first electrical contacts and the second electrical contacts and the combined channel (290) is configured to dissipate heat generated by the circuit (210).

## Description

### CROSS-REFERENCE TO RELATED PATENT APPLICATIONS

This application claims the benefit of and priority to U.S. Provisional Application No. 63/596,518, filed on November 6, 2023, which is incorporated herein by reference in its entirety.

### TECHNICAL FIELD

This disclosure generally relates to systems and methods of forming semiconductor devices, including without limitation forming semiconductor devices with metal contacts and cooling channels.

### BACKGROUND

Semiconductor devices can be designed in various ways and for a range of applications. During operation, semiconductor devices can generate heat, which unless dissipated, can adversely affect the performance of these devices. Depending on the design, semiconductor devices can be integrated with other circuits or systems making it challenging to manage the device temperature.

### SUMMARY

Integrating circuits, such as semiconductor integrated circuits (ICs), into a package or a system can be challenging when dealing with high-power-density ICs that generate an amount of heat that air cooling alone may not sufficiently dissipate. Such heat generating ICs can be powered or electrically connected using vertically oriented, electrically conductive contacts, sometimes referred to as through substrate vias (TSVs) that can run through the material beneath the ICs and couple with the bottom of the ICs. In such configurations, it can be difficult to use the same material already occupied by the TSVs for effective heat dissipation from the ICs. The technical solutions of the present disclosure overcome these challenges by providing a composite multi-substrate structure facilitating electrical interconnectivity using vertical routing of TSVs beneath the ICs, alongside cooling fluid channels routed through the composite multi-substrate structure for providing electrical dissipation through the fluid run through the channels. In doing so, the technical solutions facilitate both electrical interconnectivity of the ICs using TSVs routed beneath the ICs, while also providing improved heat dissipation using the fluid channels.

An aspect of the technical solutions is directed to a system. The system can include a first substrate comprising a circuit coupled with a first plurality of electrical contacts etched perpendicular with respect to a first surface of the first substrate. The system can include a second substrate comprising a second plurality of electrical contacts etched through the second substrate and perpendicular with respect to a first surface of the second substrate. The one or more channels can be etched between the second plurality of electrical contacts and through the second substrate and oriented perpendicular to the second plurality of electrical contacts. The system can include a third substrate comprising a third plurality of electrical contacts etched perpendicular to a first surface of the third substrate. The one or more channels can traverse through at least the second substrate and can be enclosed by the first substrate, the second substrate and the third substrate. The circuit can be electrically coupled with the third plurality of electrical contacts via the first plurality of electrical contacts and the second plurality of electrical contacts and the channel is configured to dissipate heat generated by the circuit.

The system can include a first bond between the first surface of the first substrate and the first surface of the second substrate to couple the first plurality of electrical contacts with the second plurality of electrical contacts. The system can include a second bond between the first surface of the third substrate and a second surface of the second substrate opposite of the first surface of the second substrate to couple the second plurality of electrical contacts with the third plurality of electrical contacts.

The system can include the one or more channels configured to contain a cooling fluid moved through the one or more channels to dissipate the heat generated by the circuit away from the circuit. The system can include the one or more channels configured to place a cooling fluid contained within the one or more channels in a physical contact with at least a portion of the first surface of the first substrate.

The system can include a fourth substrate and a fourth plurality of electrical contacts etched through the fourth substrate and perpendicular with respect to a first surface of the fourth substrate. The system can include a second one or more channels etched between the fourth plurality of electrical contacts and through the fourth substrate and oriented perpendicular to the fourth plurality of electrical contacts. The fourth substrate can be bonded with the second substrate to couple the second one or more channels of the fourth substrate and the one or more channels of the second substrate to form a combined one or more channels. The combined one or more channels can traverse through at least the second substrate and the fourth substrate. The combined one or more channels can include a cross section whose height includes a sum of a first height of the one or more channels and a second height of the second one or more channels. The cross section can have a width corresponding to at least one of a first width of the one or more channels or a second width of the second one or more channels.

The system can include a plurality of fins formed using at least the second substrate, the plurality of fins comprising at least a first fin of the plurality of fins separated from at least a second fin of the plurality of fins by a channel of the one or more channels. Each of the first fin and the second fin can form a part of a sidewall of the channel and comprising at least one electrical contact of the second plurality of electrical contacts traversing a height of each respective fin.

The system can include a device die comprising the circuit. The device die can include an interconnect layer disposed on, or adjacent to, a second surface of the first substrate. The system can include a device die comprising the circuit having an interconnect layer disposed on, or adjacent to, the first surface of the first substrate. At least a portion of the first surface can be configured to be in a physical contact with a fluid within the one or more channels. The first substrate can be bonded with the second substrate to axially align one or more of the first plurality of electrical contacts with one or more of the second plurality of electrical contacts.

The system can include one or more pads comprising an electrically conductive material formed between one or more of the first plurality of electrical contacts of the first substrate and one or more of the second plurality of electrical contacts of the second substrate. The one or more of the first plurality of electrical contacts can be electrically coupled with the one or more of the second plurality of electrical contacts via the one or more pads. The circuit can be configured to receive electrical power for operating the circuit via the third plurality of electrical contacts coupled with the circuit via the first plurality of electrical contacts and the second plurality of electrical contacts. The system can include an inlet port to input a cooling fluid into the one or more channels and an outlet port to output the cooling fluid out of the one or more channels.

An aspect of the technical solutions is directed to a method. The method can include etching a first plurality of electrical contacts perpendicular with respect to a first surface of a first substrate comprising a circuit. The method can include etching a second plurality of electrical contacts perpendicular with respect to a first surface of a second substrate a second substrate. The method can include etching one or more channels between the second plurality of electrical contacts and through the second substrate. The one or more channels can be oriented perpendicular to the second plurality of electrical contacts. The method can include etching a third plurality of electrical contacts perpendicular to a first surface of a third substrate. The method can include bonding the first substrate, the second substrate and the third substrate to electrically couple the circuit with the third plurality of electrical contacts via the first plurality of electrical contacts and the second plurality of electrical contacts and to enclose the one or more channels traversing through at least the second substrate by the first substrate, the second substrate and the third substrate to dissipate the heat generated by the circuit.

The method can include forming a first bond between the first surface of the first substrate and the first surface of the second substrate to couple the first plurality of electrical contacts with the second plurality of electrical contacts. The method can include forming a second bond between the first surface of the third substrate and a second surface of the second substrate opposite of the first surface of the second substrate to couple the second plurality of electrical contacts with the third plurality of electrical contacts. The method can include configuring the one or more channels to contain a cooling fluid moved through the one or more channels to dissipate the heat generated by the circuit away from the circuit. The one or more channels can be configured to place the cooling fluid in a physical contact with at least a portion of the first surface of the first substrate.

The method can include etching a fourth plurality of electrical contacts through the fourth substrate and perpendicular with respect to a first surface of the fourth substrate. The method can include etching a second one or more channels between the fourth plurality of electrical contacts and through the fourth substrate, the second one or more channels oriented perpendicular to the fourth plurality of electrical contacts. The method can include bonding the fourth substrate with the second substrate to couple the second one or more channels of the fourth substrate and the one or more channels of the second substrate to form a combined one or more channels. The combined one or more channels can traverse through at least the second substrate and the fourth substrate. The combined one or more channels can include a cross section whose height includes a sum of a first height of the one or more channels and a second height of the second one or more channels. The cross-section can have a width corresponding to at least one of a first width of the one or more channels or a second width of the second one or more channels.

The method can include forming a plurality of fins using at least the second substrate. The plurality of fins can comprise at least a first fin of the plurality of fins separated from at least a second fin of the plurality of fins by a channel of the one or more channels. Each of the first fin and the second fin can form a part of a sidewall of the channel and comprising at least one electrical contact of the second plurality of electrical contacts traversing a height of each respective fin. The method can include providing a device die comprising the circuit. The device die can include an interconnect layer disposed on, or adjacent to, at least one surface of the first substrate. The at least one surface can include at least a portion of the at least one surface configured to be in a physical contact with a fluid within the one or more channels. The method can include forming one or more pads using an electrically conductive material between one or more of the first plurality of electrical contacts of the first substrate and one or more of the second plurality of electrical contacts of the second substrate. The one or more of the first plurality of electrical contacts can be electrically coupled with the one or more of the second plurality of electrical contacts via the one or more pads.

The method can include forming an inlet port to input a cooling fluid into the one or more channels. The method can include forming an outlet port to output the cooling fluid out of the one or more channels. The method can include configuring the circuit to receive electrical power for operating the circuit via the third plurality of electrical contacts coupled with the circuit via the first plurality of electrical contacts and the second plurality of electrical contacts.

An aspect of the technical solutions is directed to a structure having a composite substrate for cooling a circuit using one or more channels. The structure can include a composite substrate having a first substrate comprising a circuit coupled with a first plurality of electrical contacts etched perpendicular with respect to a first surface of the first substrate. The composite substrate can include a second substrate comprising a second plurality of electrical contacts etched through the second substrate and perpendicular with respect to a first surface of the second substrate. The second substrate can include one or more channels etched between the second plurality of electrical contacts and through the second substrate and oriented perpendicular to the second plurality of electrical contacts. The composite substrate can include a third substrate comprising a third plurality of electrical contacts etched perpendicular to a first surface of the third substrate. The composite substrate can include a first bond between the first substrate and the second substrate and a second bond between the second substrate and the third substrate to electrically couple the circuit with the third plurality of electrical contacts via the first plurality of electrical contacts and the second plurality of electrical contacts and to enclose the one or more channels traversing through at least the second substrate by the first substrate, the second substrate and the third substrate. The one or more channels configured to dissipate the heat generated by the circuit.

### BRIEF DESCRIPTION OF THE DRAWINGS

These and other aspects and features of the present embodiments will become apparent to those ordinarily skilled in the art upon review of the following description of specific embodiments in conjunction with the accompanying figures.
FIG. 1 is an example of a system that includes a device on a package substrate, in accordance with aspects of the technical solutions.
FIG. 2 illustrates multiple views of an example device or a structure with cooling fluid channels alongside TSVs, in accordance with aspects of the technical solutions.
FIG. 3 illustrates additional views of example devices or structures with convection cooling fluid channels alongside TSVs, using, for example, stacked wafers arrangement, in accordance with aspects of the technical solutions.
FIG. 4 illustrates examples of devices or structures with inlet and outlet ports for fluid channels for convection cooling, in accordance with aspects of the technical solutions.
FIG. 5 is an example process flow for manufacturing or fabricating an example device or a structure including fluid channels alongside TSVs, in accordance with aspects of the technical solutions.
FIG. 6 is a continuation of the example process flow for manufacturing or fabricating an example device or a structure including fluid channels alongside TSVs, in accordance with aspects of the technical solutions.
FIGs. 7A and 7B illustrates an example of a structure or a device, in accordance with aspects of the technical solutions.
FIG. 8 illustrates an example of a structure or device, in accordance with aspects of the technical solutions.
FIG. 9 is an example of a structure or device using a fluid moving device to move fluid through the convection cooling fluid channels, in accordance with aspects of the technical solutions.
FIG. 10 illustrates an example flow diagram of a method for providing forced fluid convection cooling via one or more channels disposed alongside vertically oriented vias to a heat generating circuit.

### DETAILED DESCRIPTION

The present embodiments shall now be described in detail with reference to the drawings, which are provided as illustrative examples of the embodiments so as to enable those skilled in the art to practice the embodiments and alternatives apparent to those skilled in the art. Figures and examples below are not meant to limit the scope of the present embodiments to a single embodiment, but other embodiments are possible by way of interchange of some or all of the described or illustrated elements, or those apparent to a person of ordinary skill in the art. Certain elements of the present embodiments can be partially or fully implemented using known components, only those portions of such known components that are necessary for an understanding of the present embodiments shall be described, and detailed descriptions of other portions of such known components will be omitted so as not to obscure the present embodiments. Embodiments described in their illustrated contexts should not be limited thereto. For example, embodiments described as being implemented in semiconductor substrates should not be limited to such implementation alone, but they can include embodiments implemented in various types of substrates and other materials, as will be apparent to those skilled in the art, unless otherwise specified herein. In the present specification, an embodiment showing a singular component should not be considered limiting; rather, the present disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present embodiments encompass present and future known equivalents to the known components referred to herein by way of illustration.

Thermal management of semiconductor heat-generating integrated circuits (ICs) can be a challenge. In some designs of high-power-density ICs, natural convection can be insufficient to provide adequate cooling and forced convection cooling can be preferred. However, it can be difficult to implement forced convection cooling for ICs when such high-power ICs conduct electrical signals using electrically conductive contacts (through substrate vias or TSVs) that are formed to run vertically through the substrate material beneath the ICs generating heat. In such configurations, it can be beneficial to simultaneously maximize the heat transfer coefficient to facilitate adequate cooling of the ICs, while also maximizing the density of TSV contacts passing through the material beneath the ICs.

These solutions address challenges through a composite substrate structure in which multiple substrates are bonded to enable TSVs for vertical electrical connectivity beneath ICs alongside cooling channels etched through the composite substrate to dissipate the heat generated by the ICs. The technical solutions facilitate minimizing the size of the composite substrate structure by addressing limitations imposed by aspect ratio, diameter, and pitch of the TSVs to determine the improved TSV density and minimize constraints associated with maximum TSV depth per substrate of the plurality of substrates. By forming cooling channels between the TSVs and through the multiple bonded substrates (e.g., perpendicular to the TSVs and parallel to the surface of the composite substrate), the technical solutions can take advantage of the multitude of the substrates in the composite substrate structure to increase the cross-section of the cooling channels to provide an improved cooling fluid throughput, resulting in increased convective cooling of the ICs and facilitating improved performance (e.g., increased speed and power) of the operating ICs.

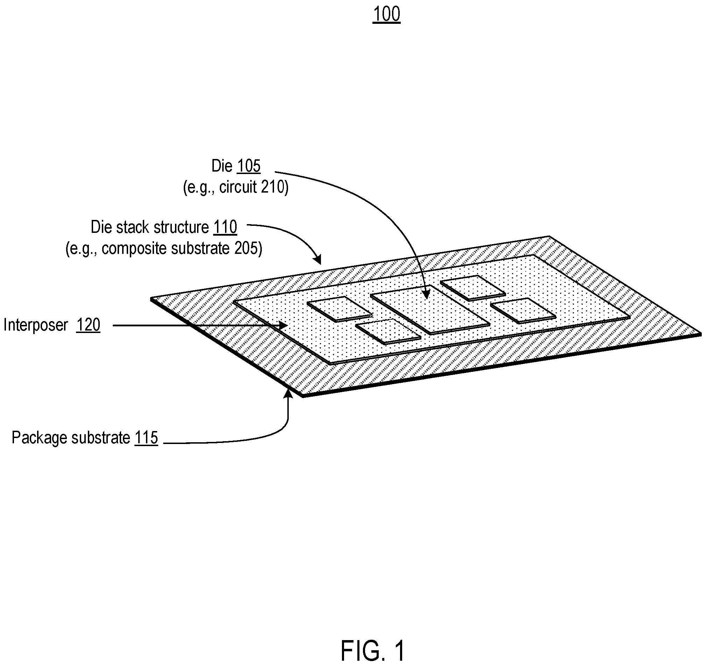

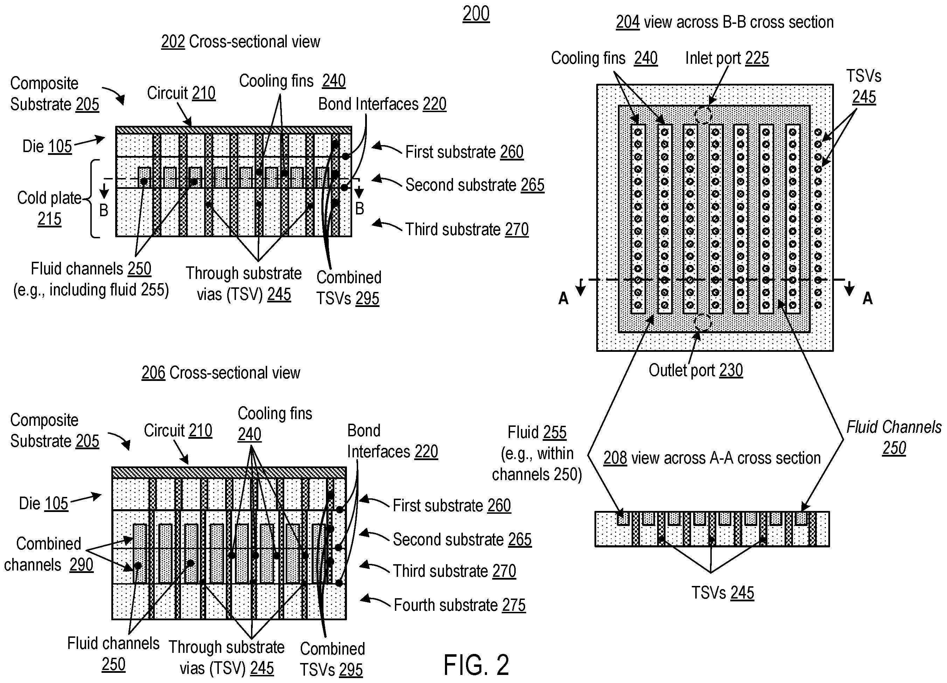

FIG. 1 illustrates an example device, structure or system 100 of the technical solutions in which a die or die stack 105 can be provided in a die stack structure 110 that can include a cold plate 215 for cooling the electrical circuits of the die 105. The cold plate 215 (e.g., shown in FIG. 2) can be formed within a die stack structure 110 and mounted on a package substrate 115. The cold plate 215 can include, or be a part of, interposer 120 or a standalone item on which die 105 or several dies 105 are attached. A package substrate 115 can be coupled with (e.g., in a thermal or physical contact with) a cold plate 215. Thermal and/or physical contact can be formed between die 105 and interposer 120.

Cold plate 215 can include or be formed within one or more substrates, interposers or dies 105 which can together form a die stack structure 110 having a circuit 210 (e.g., one or more ICs) generating heat. Die stack structure 110 can include a composite substrate 205 having any number of substrates, interposers and dies. Substrates used to form a composite substrate 205 of the die stack structure 110 can include any substrate material, such as a silicon wafer, a gallium arsenide substrate, a silicon carbide substrate, a gallium nitride substrate, a glass or a ceramic substrate, a flexible or any other substrate used for circuit manufacturing. As discussed in a greater detail, for example in FIG. 2, metal contacts or through substrate vias (e.g., TSVs) can be formed in vertical cavities (e.g., perpendicular to the surface of the substrates) through the composite substrate 205. TSVs can be integrated through multi-substrate die stack structure providing electrical connectivity between the die 105 and one or more substrates beneath of the die stack structure 110 forming the cold plate 215. The cold plate 215 can include one or more cavities, passages or otherwise cooling channels for conducting or confining a flow of a cooling fluid to provide convective cooling to the circuits 210 in the die 105.

A die 105 can include any semiconductor component that includes an electronic circuit 210 (e.g., an integrated circuit or any other heat generating electrical component) fabricated on, or within, a piece of a semiconductor material. Die 105 can include any substrate material, such as a silicon substrate, a gallium arsenide substrate, a silicon carbide substrate, a gallium nitride substrate or any other substrate used for circuit manufacturing, including for example sapphire. Die 105 can include, for example, any one or more circuits 210 implemented in, or on, or within, one or more substrates of the die stack structure 110, including a processor, a microcontroller, a graphics processing unit (GPU), a field-programmable gate array (FPGA), a power management integrated circuit (PMIC), a radio frequency (RF) power amplifier, a memory module, or a power supply. Die 105 can include any analog or digital circuit having any combination of logic gates and active or passive electronic components (e.g., resistors, capacitors, inductors), circuits for performing arithmetic functions, memory cells, flip-flop and latches circuits or clock circuitry using electricity and generating heat. Die 105 can include a single physical part of a semiconductor substrate, processed to include one or more circuits and configured for connecting to contact lines (e.g., via pads or vias) and interfacing with other devices, components or systems.

Die 105 can be provided on a stack of substrates that can include a cold plate 215, further discussed for example in FIG. 2. Die stack structure 110 can include one or more interposers 120 which can include substrates in which high-density electrical connections and signal routing can be formed for providing electrical interconnectivity between circuits (e.g., ICs) within a single package. The die 105 having the circuit 210 can be connected to the cold plate 215 in any way that provides a strong thermal contact and contains fluid 255 of the fluid channels 250 or combined fluid channels 290. Techniques used for connecting the dies 105 with cold plates 215 can include, for example, hybrid bonding and under-bump metallization (ubump). Interposer 120 can include, for example a silicon interposer, such as a layer of silicon material with a network of electrically conductive interconnects. Interposer can include, for example, a semiconductor interposer for 2.5D or 3D integration, which can be configured or used to stack multiple dies 105 on top of one another (e.g., to form a die stack structure 110). 2.5D integration can include placing multiple integrated circuits on an interposer or substrate and can utilize through-silicon vias (TSVs) for vertical electrical connections. 2.5D integration can use an underlying structure assembled, such as having multiple circuits together on a common substrate that are side-by-side. 3D integration can include a structure in which multiple integrated circuits 210 are stacked on top of one another, such as processors, memory, logic or sensors. The cold plate 215 can include any or all of the functionality of an interposer 120. Once assembled, cold plate 215 can include passages for fluids. Cold plate 215 can interconnect multiple circuit element, such as a memory, logic and sensors.

Interposers 120, substrates or dies 105 can form a cold plate 215 within a composite substrate 205 which can include any number of TSVs integrated therethrough. The die stack structure 110 can include TSVs vertically oriented with respect to the surface of the substrates. The die stack structure 110 can include channels, such as cavities, voids or openings etched or otherwise formed within the composite substrate 205. Channels can include cavities, voids or openings formed through the composite substrate and oriented perpendicular to the TSVs (e.g., parallel to the surface of the substrates and traversing through one or more substrates of the multi-substrate die stack structure 110) to provide cooling to the heat generating ICs of the die 105. The technical solutions can apply to the system 100 or any portion of it, such as below or above any top die 105, any bottom die 105, or within any layer of the die stack structure 110, including any material in between the dies 105, such as within one or more interposers 120 or substrates between two or more dies 105 having circuits 210.

FIG. 2 provides example device, system or structure 200 integrating TSVs oriented vertically through a composite substrate 205 alongside channels traversing the composite substrate 205 perpendicular with respect to the TSVs and providing convective cooling. FIG. 2 can provide a cross sectional view 202 of a three-substrate composite substrate 205 example, a view across a B-B cross section (e.g., plan view) 204, a cross-sectional view 206 of a four-substrate composite substrate 205 example and a view across A-A cross section 206. These examples can include structures having multiple substrates bonded together to form composite substrates 205 providing cooling via fluid channels 250 routed through the composite substrates parallel to the surface of the composite substrates 205, alongside and perpendicular to the TSVs 245 vertically oriented (e.g., perpendicular) with respect to the plane of the composite substrate 205.

View 202 illustrates a cross-sectional view of a structure or device 200 having three-substrate composite substrate 205. Composite substrate 205 can include a die 105 having one or more circuits 210. Die 105 can be mounted, attached, bonded or otherwise coupled on top of a cold plate 215 having a plurality of substrates, such as substrate 260 that can be bonded with the die 105 via a first bond interface 220, a second substrate 265 that can be bonded with the first substrate 260 via a second bond interface 220, and a third substrate 270 that can be bonded with the second substrate 265 via a third bond interface 220. Through substrate vias (TSVs) 245 can be formed within cavities etched, drilled or otherwise formed through individual substrates of the composite substrate 205 to form combined TSVs 295 traversing multiple substrates of the composite substrate 205. Depending on the design, TSVs 245 can be etched or formed in cavities that can be etched at an angle, such as an angle of 5, 10, 15, 20, 30, 45, or more than 45 degrees with respect to a perpendicular orientation with respect to surface of the composite substrate. Etching can include a process of selectively removing material from a substrate, such as a surface of the substrate, using chemical, physical or mechanical means.

TSVs 245 can be formed by filling the etched cavities of the TSVs with electrically conductive material, such as metals (e.g., copper or aluminum). TSVs 245 can be connected with contacts of the circuit 210, such as at the bottom side of the circuit 210. TSVs 245 can be routed perpendicular with respect to the surface of the composite substrate and extend downwards towards the first, second and third substrates (e.g., 260-270) of the cold plate 215. Cooling fins 240 can be formed between the channels 250 containing cooling fluid 255 for extending the surface area with respect to the cooling fluid 255 and improving the dissipation of the heat away from the circuit 210 and the composite substrate 205.

Similar to a composite substrate 205 structure in view 202 showing three substrates forming a cold-plate 215, an example structure of view 206 shows a cross-section of a composite substrate 205 having a cold plate 215 formed using four substrates (e.g., 260, 265, 270 and 275). Composite substrate 205 of view 206 provides combined TSVs 295 and combined channels 290 that can traverse multiple substrates of the composite substrate 205. Example structure in view 206 can include one or more circuits 210 in a die 106 that can correspond to a first substrate 260. TSVs 245 can be coupled to the circuit 210 and extend downward through the composite substrate 205 across multiple bond interfaces 220. Bond interfaces 220 can be formed by bonding first substrate 260 to the second substrate 265, a second substrate 265 to a third substrate 270 and the third substrate 270 to a fourth substrate 275. Combined TSVs 295 can be formed by electrically coupling individual TSVs 245 formed within each of the individual substrates, each one resulting in a single, continuous electrical contact traversing the thickness of multiple substrates of the composite substrate 205.Combined channels 290 can be formed by aligning and combining individual fluid channels 250 with each other to form channels having a larger (e.g. combined) cross-sectional area, facilitating a larger throughput of the cooling fluid 255 though the combined channel 290, resulting in improved heat transfer.

Example structures in views 202 and 206 can include composite substrates 205 which can be formed using any substrate bonding, Substrate bonding can include any precise and permanent attachment of two or more substrate (e.g., semiconductor wafers) to form a single integrated structure (e.g., structure 200 or die stack structure 110). Bonding interfaces 220 can include surfaces of two adjacent substrates in the stack being bonded together. In some implementations, substrate bonding or bonding of substrate surfaces may not necessarily include bonding of the surfaces directly to one another (e.g., placing them in a direct physical and/or thermal contact), but rather a bonding can occur through intervening layers, materials (e.g., a deposited layer of material).

Cold plate 215 can be formed using a plurality of substrates (e.g., 260, 265, 270 and 275) which can be bonded together via any number of bond interfaces 220. For instance, a first substrate 260 and a second substrate 265 can be aligned together and bonded such that their respective pre-formed TSVs 245 are placed in an electrical contact, thereby providing a combined TSV 295 routing through multiple substrates (e.g., 265 and 270) of the composite substrate 205. TSVs 245 and combined TSVs 295 can be routed perpendicular with respect to the plane of the die 105 or substrates 260 and 265 or can be sloped at any angle with respect to the perpendicular orientation. First substrate 260, located between the die 105 on top and second substrate 260 below, can include any number of TSVs 245 traversing the thickness of the substrate 260 (e.g., providing electrical connectivity between the first (e.g., top) surface of the first substrate 260 interfacing with the die 105 and a second (e.g., bottom) surface of the first substrate 260. First substrate 260 may or may not include at least a portion of one or more fluid channels 250 through which fluid 255 can be moved or propagated in order to provide fluid-based convection cooling to the circuit 210.

Die 105, which can also be referred to as a device die 105, can include a die 106 having any number of heat generating circuits 210. Die 105 can include a device layer that can include an interconnect layer. The interconnect layer can include electrically conductive contacts or lines for the circuit 210, such as metal conductors for interconnecting various parts of the circuit 210. For instance, an interconnect layer can include copper or aluminum lines or contacts for providing electrical connectivity for various transistors, capacitors and resistors of the IC. The interconnect layer can be insulated using a grown insulating layer and can be buried underneath the surface of the composite substrate 205.

Circuit 210 can include any combination of interconnected electronic components or conductive and semiconductive materials or features configured to perform specific electrical functions. Circuit 210 can include any combination of electrical or electronic components, features for creating, processing, controlling, adjusting, receiving or transmitting electrical signals. Circuit 210 can include any heat generating electronic component of a die 105, including a digital logic circuit, an analog circuit, a microprocessor circuit, a radio frequency (RF) circuit, a power management circuit, a sensor circuit, memory circuitry or any other circuit that can be provided by a die 105. During its operation, circuit 210 can generate heat, which can adversely affect operation of the circuit 210 or any other neighboring circuitry or a system, unless such heat is dissipated by the cold plate 215, using its cooling fluid channels 250.

Fluid channels 250, also referred to as cooling channels 250 or channels 250, can include any one or more cavities, pathways or conduits for enclosing a cooling fluid 255 (e.g., liquid or gas) that can be moved through the channels 250 to dissipate the heat from circuit 210. Fluid channel 250 can include a trench etched into surface of a substrate (e.g., a top surface of a second substrate 265). Channel 250 can be enclosed or sealed by the same substrate into which it is etched, or it can be sealed or enclosed by multiple substrates. For instance, a first substrate 260 can provide a ceiling (e.g., a top surface) of the channel 250, a second substrate 265 can provide the sidewalls of the channel 250 and a third substrate 270 can provide the floor (e.g., the bottom surface) of the channel 250, thereby having all three substrates 265-270 forming the channel 250 containing the fluid 255 therein.

The sealing or enclosing of the fluid channels 250 can be implemented using wafer bonding to form one or more bonding interfaces 220. Bonding of substrates (e.g., 265-270) can include joining any two substrates together to eliminate gaps or spacing between them, such as by using fusion bonding or adhesive bonding under controlled conditions. Bonded substrates can include channels 250 etched into the surfaces being bonded. Etching can include selective removal of substrate material from a surface of a substrate, or through the entire thickness of the substrate, using for example dry or wet etching processes. Etching can be implemented along one or more patterns to create the cavities or holes for the TSVs alongside the trench lines for channels 250, to remove the material from the substrate to allow for filling of the TSVs 245 and channels 250.

Fluid channel 250 can seal or enclose a fluid 255 (e.g., liquid or gas) within all sides of the channel 250 (e.g., top or ceiling, floor or bottom and sides). Channel 250 can be configured for moving fluid 255 through the channel 250 by providing one or more entrances (e.g., inlets and outlets) for the fluid 255 to enter the channel 250 and be forced, pressured, pushed or otherwise moved through the channels 250. As the channels 250 (e.g., channel structure) can be disposed beneath the circuit 210 and arranged in a plane that is parallel to the circuit 210, channels 250 can facilitate or provide heat transfer from the circuit 210, via the material of the composite substrate 205 to the fluid 255 moving through the channel 250. For instance, one or more channels 250 can be arranged or shaped to form a parallel plane or surface within the composite substrate 205 and beneath the die 105 to provide a cold plate 215 for cooling of the die 105.

Channels 250 along with the substrate material can form cooling fins 240. Cooling fins 240 can be formed by etching of the substrate materials between a two-dimensional array of channels 250. A cooling fin 240 can include sidewalls of one or more (e.g., two) adjacent channels 250. For instance, one sidewall of a cooling fin can form a sidewall (e.g., a left wall) of a first channel 250 and a second sidewall of the cooling fin 240 can form a sidewall (e.g., a right wall) of a second channel 250. Cooling fins 240 can have dimensions that are same or different in different axes. Fins 240 can be patterned to have same or different sizes and shapes.

Fins 240 can be arranged to form a single channel 250 (e.g., a single flow path) beneath the die. Single channel 250 can be formed to include a serpentine shaped path, and can form, for example, a zigzag pattern, or a pattern having one or more turns or direction changes to span or cover an area underneath the circuit. Single channel 250 configuration can include a channel moving in a plane that is parallel to and located beneath the circuit 210 allowing fluid 255 to flow across an area beneath the circuit 210. The one or more channels 250 can also be arranged to effectively flow through the entire region of the die, or just part of it. The one or more channels 250 can include any combination of topologies, including any shapes or routes, such as straight or curved lines, curvatures, bends, corners, portions of the channels having same or different widths, heights or lengths, or any other shape or form variation.

Channels 250 and fins 240 can be etched or machined through any number of substrates (e.g., 265-270) in any combination or orientation. For instance, channels 250 and fins 240 can be configured or designed to form a network of passages through which a cooling fluid 255 (e.g., liquid coolant or gas) can flow in a single channel configuration or a multi-channel configuration. The network of passages can include one or more single channel 250 connecting to other one or more channels 250, forming an array or grid of channels 250, a set of straight parallel channels 250, a single serpentine, winding or a curvilinear shaped (e.g., curved, zig-zag or s-shaped) channel with straight line channel sections and curved channel portions to cover or span an area or a volume, or any arrangement, shape or orientation beneath the die 105.

For example, a serpentine (e.g., single) channel 250 may or may not form fins 240. In some instances, the design can include an array of fins. For example, a design can include a single row of fins. The design can include fins 240 whose height is orthogonal with respect to the TSVs 245. For instance, design can include one or more interweaved 2-D arrays of fins 240 that are offset, and that can have a hexagonal or aperiodic lattice, or be uniquely spaced apart.

When circuits 210 generate heat, the cooling fluid 255 having temperature lower than that of the composite substrate 205 can circulate through the channels 250. By having a lower temperature than that of the surrounding material (e.g., substrates 260 and/or 265), fluid 255 can receive the heat from the fins 240 and other surfaces of the channel 250. The heat can be transported away from the die 105, via the fluid 255 which can be heated in the process of flowing through the die, taking the heat out of the composite substrate 205 upon exiting the structure. Fluid channels 250 can include cross-sections of any shape, such as rectangular or curved (e.g., circular), square, trapezoidal, hexagonal, triangular, oval or any other shape.

Fluid 255 can include any fluid, such as a gas or a liquid, which can be used for cooling the structure 200 or any portion of the composite substrate 205, including circuit 210. Fluid 255 can include a water or air, a fluorocarbon liquid, an oil, such as a mineral oil, or a refrigerant. Gases can be under pressure but not so high pressure as to cause mechanical failure. As the fluid 255 can be pumped, pushed or moved through the one or more channels 250 via a fluid moving device (e.g., a cooling pump or a fan device), the fluid 255 can be replenished in the channels 250.

Through substrate vias (TSVs) 245, also referred to as vias 245, can include or be filled with any conductive material, electrical contact, and provide electrically conductive pathway inside of one or more semiconductor substrates. TSVs 245 can include any electrically conductive pathway or material, including for example heavily doped semiconductor material, designed to transfer electrical signals. TSVs 245 can include elongate electrical contacts providing a pathway for electrical signals routed beneath and coupled with a die 105. A TSV 245 can include a metal material deposited or filled inside of a cavity or a hole (e.g., a through-hole) of one or more substrates (e.g., 105, 120, 260, 265, 270 or any other) to provide an electrically conductive pathway from one surface of the substrate to the opposite surface. Vias 245 can be oriented or arranged into a direction perpendicular or vertical with respect to the die 105 and/or substrates 260 or 265, or at any slope angle. For instance, TSV 245 can be formed by etching vertically oriented (e.g., downward) holes or cavities in a first substrate 260 and a second substrate 265 and filling each of the holes or cavities with electrically conductive material (e.g., copper, nickel, or tungsten, or any other electrical conductor).

Combined TSVs 295 can be formed by combining multiple TSVs 245 from multiple substrates (e.g., 260-270) to form a single elongate electrically conductive via spanning such multiple substrates. Combined TSV 295 can include a first TSV 245 etched and formed through a first substrate 260 and a second TSV 245 etched and formed through a second substrate 265. Combined TSV 295 can be formed using any number (two, three or more) TSVs 245 formed through any number of substrates and interconnected via substrate bonding or any other techniques.

Individual TSVs 245 from different substrates can be aligned (e.g., coaxially lined up to connect end-to-end) with each other to form an electrical coupling and form a single combined TSV 295 traversing through the substrates. Combined TSV 295 can be formed, for example, by aligning individual TSVs 245 to each other in the course of a zero-clearance bonding, such as a hybrid bonding. Zero-clearance bond can connect edges of individual TSVs 245 from two substrates along the bond interface 220, connecting TSVs 245 of a first substrate with TSVs 245 of a second substrate and connecting insulating or semiconductor surfaces of the first substrate with insulating or semiconductor surfaces of the second substrate. For instance, a zero-clearance bond can be used such that insulator materials of the substrates are lined up and connected with each other and that conductor materials are lined up and connected or bonded with each other. The conductors can be made of more than one material, including for example conductive barriers. Insulators can be made up of multiple layers as well of insulating materials.

Combined TSV 295 can be formed in various ways. For instance, two or more TSVs can be connected directly to one another (e.g., end to end physical contact) to form a combined TSV 295. Multiple TSVs 245 can be electrically coupled with each other to form a combined TSV 295 via one or more intervening electrically conductive bonding pads (e.g., TSV pads 305) which can be formed or disposed between the TSVs 245 to provide electric connectivity therebetween. For instance, a zero-clearance bonding can be used to bring together two ends of two TSVs 245 in two substrates to electrically couple with each other via a bonding pad providing a wider surface area for connecting the TSVs 245 to form a single combined TSV 295. In such configurations, a TSV 245 can include a first part of a via routed through a first substrate 260 and a second part of the via routed through the second substrate 260. The two TSVs 245 can be coaxially aligned with each other to electrically couple with each other directly (e.g., end to end) or via a TSV pad (e.g., 305) to form a single combined TSV 295 traversing multiple substrates of the composite substrate 205, seamlessly connected to each other through alignment and/or fusion or bonding. TSVs 245 can be axially aligned (e.g., be collinear, oriented in a same line or direction and touching end to end), forming a single straight combined TSV 295. TSVs 245 can be misaligned but electrically coupled, connected or bridged using metal pads or horizontal metal contacts or lines, forming combined TSVs 295 using such pads or offset contacts. For instance, the axial alignment can be off center while also being sufficient to form electrical connection so as to conduct electrical signals.

Combined channels 290, such as those illustrated in the example structure of cross-sectional view 206, can be formed by combining channels 250 of multiple bonded substrates. Combined channel 290 can include for example, multiple aligned channel structures etched through multiple aligned substrates (e.g., 265 and 270), which can then be covered by a substrate (e.g., 260) providing a top surface seal and a bottom substrate (e.g., 275) providing a bottom cover of the combined channel 290. Combined channel 290 can include any number (e.g., two, three, four or more than four) channels 250 etched within or through any number (e.g., two, three, four or more than four) substrates (e.g., 260-275). Combined channel 290 can be interfacing with combined fins 240 forming the sidewalls of the combined channel 290. Such fins 240 of the combined channel 290 can form a combined fin traversing multiple substrates as it forms the combined channel 290.

Cooling fins 240 can include any structure, projection, ribs, protrusion, surface roughness, or extended feature for dissipating heat by increasing the surface area exposed to a cooling fluid 255. Cooling fins 240 can include any heat dissipating structure designed or used to improve heat transfer from itself to a cooler medium, such as a cooling fluid 255 within a channel 250 or a combined channel 290. Cooling fins 240 can include any combination of substrate materials, such as the first substrate 260 or second substrate 265. In some configurations, cooling fins 240 can include at least a portion of TSV 245 exposed to cooling fluid 255. Each of the substrates 260 or 265 can include semiconductor substrates (e.g., silicon, gallium arsenide, silicon carbide), glass, or ceramics. Cooling fins 240 can include TSVs 245. Cooling fins 240 can include a projecting structure exposed to, or in physical or thermal contact with, a cooling fluid 255, along one or more sides of the fin. Cooling fins 240 can be combined (e.g., end-to-end aligned and stacked one on top of another) to form combined fin structures traversing multiple substrates of a combined substrate 205 and forming sidewalls of the combined channels 290.

Thermal contact can include any connection, path or interface between two materials or objects that facilitates heat transfer, whether in direct physical contact or through an intervening thermally insulating structure or medium. For example, thermal contact may or may not include a direct thermal or physical contact. For example, thermal contact can include intervening layers or barriers of thermal insulator material films through which heat can be conducted or dissipated.

Cooling fin 240 can include a surface area in a physical or thermal contact with fluid 255 within one or more channels 250. Cooling fins 240 can include a substrate material having a high thermal conductivity (e.g., between about 50-400 W/m*K, or more than 400 W/m*K) facilitating improved heat transfer. Cooling fins 240 can include one or more TSVs 245, routed vertically through the substrate material (e.g., along the height of the cooling fins) and serving as conduits for the efficient transfer of heat from the electronic components to the substrate. Cooling fin 240 can include or be embedded, perforated or traversed by one or more TSVs 245 or combined TSVs 295, which can extend (e.g., perpendicularly) down the fin 240. For instance, a cooling fin 240 can include a plurality of TSVs 245 traversing or extending through the cooling fin 240, such as along the height of the TSV 245. TSV 245 can include thermally conductive material and facilitate in heat dissipation from the cooling fin 240 to the fluid 255.

A bond interface 220 can be used to attach, connect, join, couple or bond a die 105 (e.g., device layer 205 or integrated circuit 210) with a substrate (e.g., 260 or 265) in which cooling fins 240 and fluid channels 250 can be formed. Bond interface 220 can be created via wafer bonding of substrates (e.g., dies 105 or substrates 260 or 265), such as for example permanently attaching two semiconductor wafers together into a single integrated structure. Bond interface 220 can be implemented at the atomic or molecular level, such as using direct bonding, adhesive bonding or fusion bonding. The structure 200 can be formed by wafer bonding of the die 105 with one surface of the first substrate 260 and wafer bonding a second substrate 265 with another surface of the first substrate 260 to form the cold plate 215 with the first substrate 260 and the second substrate 265 for the die 105 and its circuit 210. Bond interface 220 can be formed using any number of techniques. For example, bond interface 220 can be implemented using surface activation using a layer of oxide on one or more surfaces to facilitate bonding. Bonding interface 220 can be implemented using direct bonding.

While example structures or systems shown in views 202 and 206 illustrate examples in which die 105 is turned away from the surface interfacing with the cold plate 215, it is understood that depending on the design, the surface of the die 105 having the circuit 210 can be oriented towards the cold plate 215 and be aligned with the cold plate 215. For instance, circuit 210 can be located at a surface that is opposite of the first bonding interface 220 between the die 105 and a substrate of the cold plate 215 (e.g., substrates 260-275). For instance, circuit 210 can be located at or near (e.g., adjacent to) a surface of the die 105 that interfaces with (e.g., is in physical contact with or forms a bond interface 220) with the substrate of the cold plate 215 (e.g., 260-275). In such a configuration, the channels 250 (e.g., or combined channels 290) can be placed in a proximity to the circuit 210 or can be in physical contact with a portion of the circuit 210, thereby reducing thermal resistance between the circuit 210 and the channels 250 and improving heat transfer.

View 204 of FIG. 2, provides a cross-sectional plan view (e.g., top-down view) of the composite substrate 205 cut across the plane of the one or more channels 250 (e.g., or combined channels 290). View 204 can correspond to a cross-sectional view of the composite substrate cut across the line B-B shown in the cross-sectional view 202. As shown in the view 204, TSVs 245 (e.g., or combined TSVs 295) can be disposed or formed through the fins 240 separating different channels 250 (e.g., combined channels 290) of the multi-channel structure. The multi-channel structure can include a planar arrangement of parallel array of channels 250 and TSVs 245 arranged or pitched in lines or columns traversing through the cooling fins 240.

As illustrated in view 204, TSVs 245 can be routed or pitched at any pitch arrangement through the fins 240. Provided or routed beside (e.g., to the left or to the right of) each channel 250 or in between any two channels 250 can be any number of TSVs 245 that can be oriented or routed in a direction that is orthogonal or perpendicular to the plane along which fluid channels 250 are formed. Depending on the implementation, TSVs 245 can be sloped along one or more angles with respect to the channels 250.

Channel structure or arrangement (e.g., such as those in views 202 or 206) can include one or more inlet ports 225 and outlet ports 230 for facilitating the flow of the fluid 255 through the channels 250. For instance, the inlet and outlet ports can provide passages for the fluid 255 to enter or exit the fluid channels 250. Depending on implementation, one or more inlet ports 225 can be provided on one end of one or more channels 250, and one or more outlet ports 230 can be provided on the other (e.g., opposite end) of the one or more channels 250. Inlet port 225 or outlet port 230 can be arranged, formed by etching or drilling, and can include a circular, rectangular, elongated or any other shape of the opening or cross-section.

View 208 provides a cross-sectional via along a line A-A shown in the view 204, showing cross-section along a row (e.g., spanning across multiple columns of TSVs 245). View 208 provides a different view of cooling fins 240 having TSVs 245 routed vertically through and along the height of the cooling fins 240. Each TSV 245 can be separated from the channel 250 by a layer or sliver of substrate material (e.g., substrate 260 or 265) forming the cooling fin 240.

The technical solution can use a hybrid bonding surface to connect multiple wafers together and align and form the TSVs 245 and the channels 250, such as by coaxially aligning and bringing in electrical contact different parts or sections of the TSVs 245 (e.g., from different substrates). The technical solution can also align and bring together (e.g., seal) the fluid channels 250 between two or more different substrates. System 200, including its example structures shown in views 202 and 206, can use cooling fins 240 or other features (e.g., between the channels 250) to allow passage, routing or disposing of one or more TSVs 245 through the layer of channels 250 (e.g., in between individual channels 250). The technical solutions can use a hybrid bonding surface to connect different wafer substrates together, while TSVs 245 can be formed, etched or drilled through the cooling fins (e.g., fin structures) to facilitate more efficient heat distribution and cooling.

The technical solutions can include or utilize any zero-clearance bond that allows electrical connection of the through substrate. For example, fusion bonding or hybrid copper bonding technology can be used to bond, couple or connect portions of metal vias into a TSV 245. For example, one or more TSVs 245 extending orthogonally through a portion of the cold plate 215 that includes (e.g., a planar array of) fluid channels 250 can provide die side connection to the circuit 210 at the device layer 205. Examples of contacts on the circuit 210 side can include other TSVs 245, and copper bonding/landing pads to which TSVs 245 from the cold plate 215 can connect or electrically couple.

In the cold plate 215, the wafers (e.g., substrates 260-275) can be bonded so as to have TSVs 245 that can make contact to other TSVs 245 or any intervening electrical landing pads or fan out layers to form combined TSVs 295 of various structures or shapes. For instance, electrically conductive pads or other structures can be used as an electrically conductive interface connecting two offset TSV 245. Cold plate 215 can be made from silicon or any materials (e.g., glass, ceramic, or electrical insulators) or structures that allow TSVs 245 to be electrically isolated from one another. Materials used for TSVs 245 can have high thermal conductivity (e.g., metals, such as copper, tungsten, nickel). Low thermal conductivity materials can be used as thin insulating layers (e.g., 20nm film thickness) if such structures remain sufficiently thermally conductive and if heat transfer can occur across them.

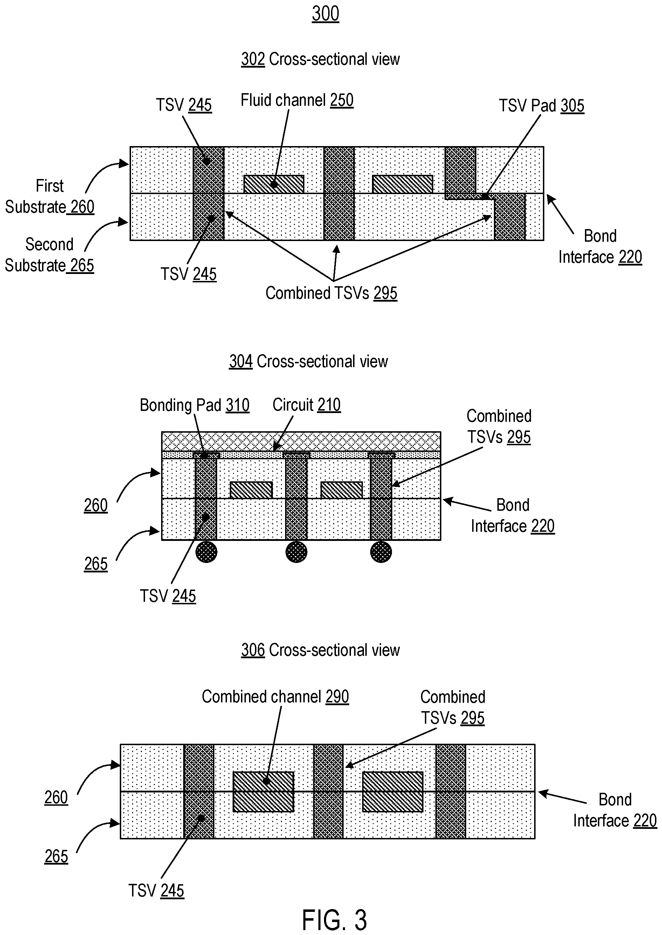

FIG. 3 illustrates various examples of a structure, device or a system 300, including additional design features or variations involving combined TSVs 295 implemented with laterally offset TSVs 245. As with example 200 in FIG. 2, examples 300 can include fluid channels 250 constructed in stacked substrates facilitating the flow of fluid 255. Example 300 can be illustrated using cross-sectional views 302, 304 and 306. While example 300 illustrates a two-wafer substrate design with a single bond interface, the technical solutions allow for construction of more complex flow paths by stacking any number of additional wafers or material on top of one another.

View 302 illustrates a cross-sectional view of bonded first substrate 260 and second substrate 265 (e.g., in a cold plate 215) having TSVs 245 and fluid channels 250. In the example configuration of view 302, one of the TSVs 245 includes an electrically conductive TSV pad 305 facilitating two TSVs 245 to be electrically connected despite a lateral shift or spatial offset between two TSV 245. As shown, for example, in the right side TSV 245, a first TSV 245 in a first substrate 260 can be offset laterally (e.g., to the left) from the second TSV 245 in the second substrate 265. To facilitate an electrical connection between the two TSVs 245, a TSV pad 305 (e.g., an electrically conductive material or a landing pad) can be disposed or formed between the two TSVs. The TSV pad 305 can include a structure or a flat area (e.g., a pad or a surface) that can include an electrically conductive material or a trace (e.g., copper, aluminum or doped semiconductor), which can be used to provide electrical continuity between the first TSV 245 (e.g., in the first substrate 260) and the second TSV 245 (e.g., in the second substrate 265). TSV pad 305 can have any shape or size facilitating the connection between the TSV 245. For example, TSV pad 305 can include a length that corresponding to a lateral offset between TSVs 245 due to a portion of a fluid channel 250 which one of the TSVs 245 can avoid by shifting to a side. In such configurations, TSV pad 305 can facilitate formation of combined TSVs 295 even when different TSVs 245 do not align with each other.

As shown in cross-sectional view 304, a die 105 can be oriented face down, having its circuit 210 on the surface of the die substate that is bonded with the cold plate 215. Circuit 210 can include electrical input or output pads or contacts exposed to TSVs 245 coming up to the bottom of the circuit 210 from the first substrate 260 beneath the die 105. Die 105 can include any number of electrical input or output pads that can be axially aligned with, and electrically coupled to, TSVs 245, via bonding pads 310. Bonding pads 310 can include electrical pads or contacts providing electrical connection between the circuit 210 and the TSVs 245. Bonding pads 310 can include any electrically conductive structures or surfaces corresponding to input or output signals or power lines of the circuits 210 which can be electrically coupled with the TSVs 245. Bonding pads 310 can be formed on the surfaces being bonded at bond interfaces 220, so as to facilitate improved electrical contacts between parts of TSVs being formed. TSVs 245 of the cold plate 215 can make contact to a bonding pad 310 on the device die and be connected with the bonding pad 310, using for example copper bonding. In such configuration, the cold plate 215 can be placed adjacent to the die 105, forming a direct or a tight physical contact.

Signal density of the TSVs 245 can be based on or related to a diameter of TSV 245. For example, TSV 245 can have a diameter of between 1um and 50um, such as 10 um diameter. TSVs 245 can be distributed along a cooling fin 240 at a pitch of between 10 um and 1000um. For example, a 5-um diameter TSV 245 could have a 45-um pitch given example metal density specifications, which can be centered along a cooling fin 240. In some aspects, a cooling fin 240 can include multiple columns of TSVs 245 of any sizes (e.g., diameters) and distributed according to any pitch. As TSV integration specifications evolve to allow for smaller pitch, those new specifications could be used.

Channel 250 can be constructed to have any height or width. For example, a height of a fluid channel 250, as well as a height of the fin 240, can be between 10um and 1000um, such as 300 um. For example, a TSV 245 can be designed such that its diameter is about 10-15 times smaller than its height, such as having an aspect ratio of between 8:1 and 15:1. Channel 250 can have a cross section that can be sized and shaped to minimize fluid impedance and cold plate pressure drop. For instance, a width of the channel 250 (e.g., the size parallel to the plane of the die 105 or a bond interface 220) can be between 10um and 5000um, such as on the order of between 50 um and 200 um.

Cooling fins 240 can have a width that can be sufficiently wide to accommodate the TSVs 245 (e.g., provide bonding surface), but also sufficiently narrow enough to maximize the number of fins to be packed into the device or maximize the cross section of the channels 250 and the flow of fluid 255. For example, if TSV is designed to be 10 um diameter, cooling fins 240 can have a width of between 50 um and 100 um. The arrangement, shape, and distribution of cooling fins 240 can be such that it maximizes pass through area for TSVs 245 and maximize fluid conductance. The high conductance flow (e.g., fluid throughput) and high TSV density can be optimized against one another. For example, for higher heat transfer characteristics the surface area of the channels 250 and the fluid 255 flow rate can be larger, limiting the area or the number of TSVs 245. For example, when the number of TSVs 245 is larger, the cross-section of channels 250 and the fluid 255 throughput can be reduced, allowing for more areas for TSVs 245.

As shown in cross-sectional view 306, when it is desirable to increase a cross section of a cooling channel 250, such as to increase the cooling fluid 255 throughput to increase heat transfer, multiple channels 250 can be combined into a combined channel 290. For example, a combined channel 290 can be formed by aligning two matching (e.g., mirror image) channels 250 in two substrates, such that the resulting height of the combined channel 290 can be increased. The height of a combined channel 290 can include a height of a first channel 250 in the first substrate 260 and a height of a second channel 250 in the second substrate 265. By aligning the two etched channels 250 and bonding their respective surfaces of the substrates (e.g., 260 and 265), a resulting combined channel 290 with a combined height of the two channels 250 can be formed.

The technical solutions can utilize thickening of the wafer substrates or etching deeper channels to increase the height of the combined channels 290 and increase the cross section. The technical solutions can use bonding of multiple (e.g., three or more) wafer substrates together and etching through the intermediary wafers to produce combined fluid channels 290 of greater cross section. For example, a combined channel 290 can include one or more intermediary substrates that are entirely drilled or etched through to be placed one on top of another (e.g., between the top and the bottom substrates) to further increase the size of the cross section, and the resulting throughput of the fluid 255. These stacking solutions can be used to reduce the TSV pitch by reducing the diameter of the TSV used for connection. For a given aspect ratio, the TSV diameter can be reduced and so the minimum pitch can be reduced also.

In semiconductor device design, optimizing the diameter and pitch of the TSV 245 can be achieved using an aspect ratio (AR) corresponding to the ratio of the TSV 245 depth (e.g., height) to its diameter) and a global density (GD) corresponding to the ratio of TSV 245 area to the total area. The maximum single substrate thickness can be determined by the maximum depth of the TSV 245, which can be based on the diameter of the TSV. The total thickness of the substrate can be determined by a sum of the depth of a channel 250 and a thickness of the substrate base thickness (e.g., when substrate base of a substrate provides the bottom surface of the channel 250). The ratio of the total thickness to substrate thickness can correspond to the minimum number of substrates used to achieve the desired composite substrate 205 structure.

In addition, a TSV diameter (d), space between TSVs (s), and derate factor that can correspond to the loss of the depth or height of the TSV 245 during processing can affect the sizing and structure design. Through thickness layer (TTL) area can be determined using pitch of the TSVs 245 squared (e.g., pitch^2). AR can correspond to the TSV depth divided by d (TSV diameter). Pitch can be equal to the sum of the d (TSV diameter) and s (e.g., space between the TSVs 245). The number of substrates combined to form the composite substrate 205 can be determined using the total TTL thickness divided by the product of TSV depth and derate factor, which can be rounded up to the nearest integer value.

Design and sizing of the structures of the technical solutions can be determined based on relationships of various features. As numerical values of feature sizes can be based on the state of processing capabilities, it is understood that processes may be improved over time, affecting some of the relations (e.g., ratios). For example, an aspect ratio (AR) of the depth of a TSV 245 to a diameter of the TSV 245 can be between 10 and 12 to 1. As such, when a diameter of a TSV 245 is 10 um, the depth of the TSV 245 can be 100-120um, which can result in the maximum substrate thickness being about 100-120um.

Likewise, the pitch, representing the spacing between TSVs 245, can range from 50 to 200 micrometers, such as for example 100 um. The channel height, bottom thickness, and derate factor can be ranged between 100-300 micrometers, 50-200 micrometers, and 0.90-0.97, respectively, with example values of the height of the channel 250 being 250 um, bottom thickness being 100 um, and derate factor being 0.9. Derate factor can correspond to a ratio of the substrate thickness to be reduced due to processing, such as polishing or grinding of the substrate for the bonding process.

In an example, a maximum TSV diameter can be set to 14 um, reflecting the diameter based on the specified AR and pitch values. The maximum TSV depth (e.g., TSV height) can be determined (e.g., based on the TSV diameter and the AR) to be 170 um, considering the height or depth of the channel 250 (e.g., 250um) and bottom thickness constraints (e.g., 100um). For the channel depth of 250um and the bottom thickness of 100um, a total TTL thickness of 350 um can be determined. The number of stacked wafers used for the given TSV dimensions can be calculated using the formula of Substrate No. = Rounded Up (TTL thickness / (TSV depth * derate factor), accounting for the derate factor to compensate for TSV loss during processing. In this example, the number of stacked wafers can be determined to be 3, indicating the minimum number of substrates needed to achieve the desired TTL thickness is 3 substrate wafers.

The solution description presents a systematic approach to optimizing the design of Through-Silicon Vias (TSVs) within semiconductor devices, providing practical insights and calculation methodologies. Initially, the utilization of aspect ratio (AR) and global density (GD) metrics is highlighted as key strategies for enhancing the TSV diameter and pitch. These metrics serve as guiding principles to ensure efficient electrical connectivity and effective heat dissipation within the semiconductor device. For example, if the AR is specified as 5:1 and the GD as 0.8, designers can adjust the TSV diameter and pitch accordingly to meet the desired performance objectives.

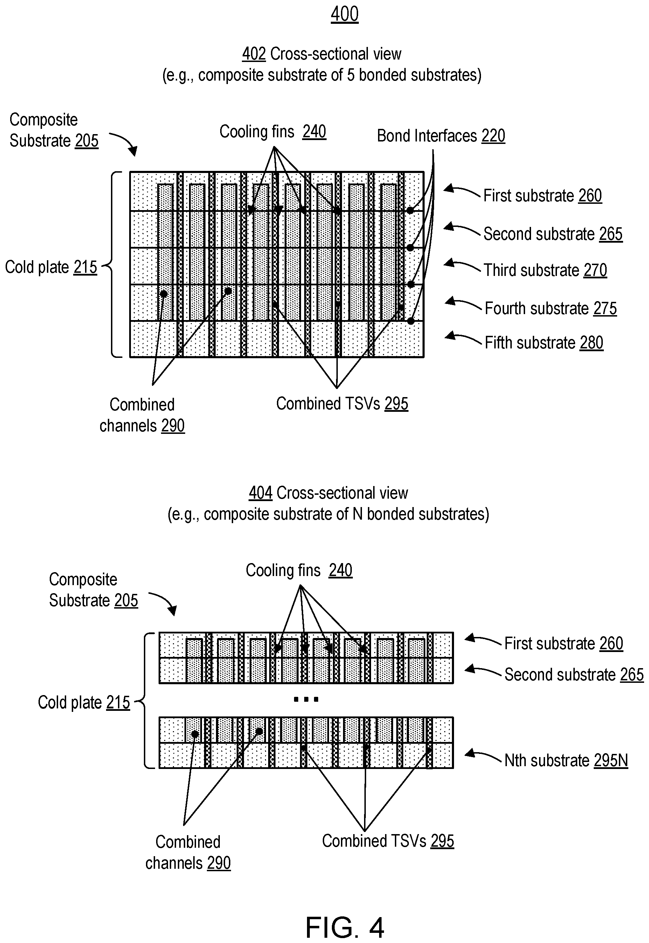

FIG. 4 illustrates additional examples of one or more systems, devices or structures implemented in composite substrates 205. In example 402, a cross-sectional view of a cold plate 215 of a composite substrate 205 composed of five substrates is illustrated. Composite substrate 205 of view 402 can include substrates 260, 265, 270, 275 and 280 bonded to each other along four bonding interfaces 220. Cooling fins 240 can be formed according to a matching pitch (e.g., matching size and shape) in each of the substrates 260-280. This can allow for the fins 240 to be stacked one on top of another, forming extended combined cooling fins 240 alongside or adjacent to combined channels 290. The combined fins 240 can include combined TSVs 295, which along with combined channels 290, can be formed within, traversing through, or otherwise in physical contact with all five substrates (e.g., 260-280) of the composite substrate 205.

As shown in example 402, cross-section of the combined channels 290 can be extended for any length by combining or stacking any number of substrates, such as substrates 260-280. As intervening TSVs 245 can be aligned and interconnected to form combined TSVs 295 through the entire stack, regardless of how many substrates are used in the stack, the final structure can vary in both height and width of the combined channels 290, thereby accommodating various ranges of fluid throughput for designs of any range of thermal throughput and specifications.

In example 404, a cross-sectional view of a composite substrate 205 having any number "N" bonded substrates is provided. Composite substrate 205 of view 404 can include any number of substrates 260 through N forming a cold plate 215. As fins 240 can be aligned and matching (e.g., mirror images of one another), the fins 240 can be stacked forming combined fins forming sidewalls of the combined channels 290 and providing material through which combined TSVs 295 can be etched and formed using deposited metal material.

In some designs, the number of substrates to be used in the stack (e.g., the composite substrate 205) can be determined based on the thermal offset that can be introduced by the bonding layers at the bond interfaces 220 between various substrates. For example, if a thermal offset of a particular thermal resistance is added or introduced at every bond interface 220, a desired (e.g., optimal) number of substrates to be used in the stack can be based at least on the thermal offsets being introduced. For example, when determining the number of substrates to include, the determination can be based on a cross-sectional area of the combined channels 290 and the sum of thermal offsets introduced at the bond interfaces 220 per a given surface area (e.g., circuit 290 area).

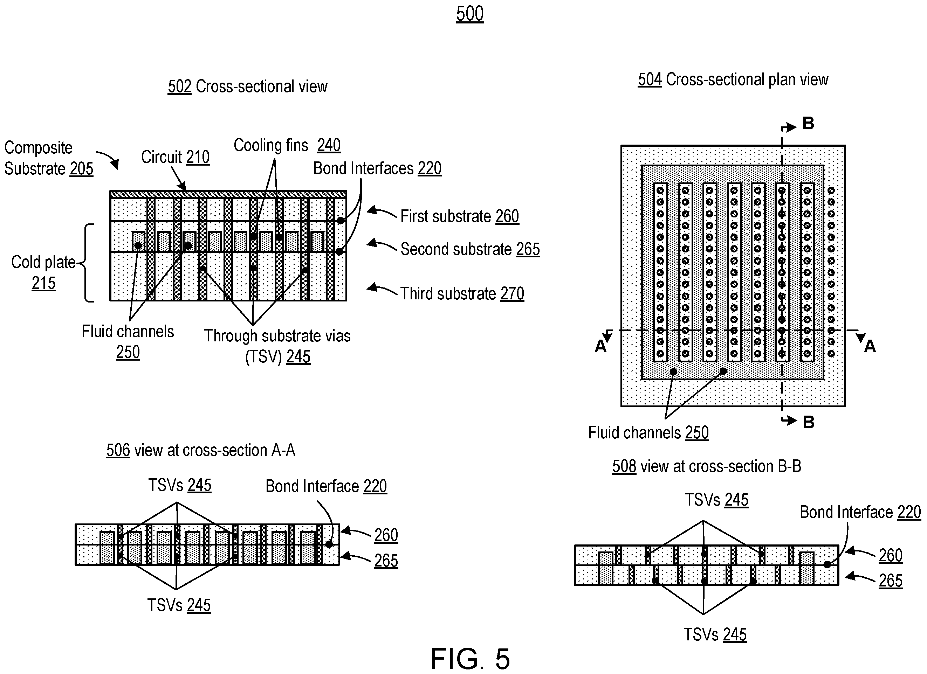

FIG. 5 illustrates an example 500 of a system, device or a structure similar to that of view 202 in FIG. 2. As shown in view 502, composite substrate 205 can include a circuit 210 having TSVs 245 bonded to the circuit 210 through the bottom portion of the circuit 210. TSVs 245 can traverse first substrate 260 (e.g., die 105), as well as the second substrate 265 bonded with the first substrate 260 and the third substrate 270 bonded with the second substrate 265. Fluid channels 250 can be formed in the second substrate and can be capped or sealed at its bottom end by the top surface of the third substrate 270.

Cross-sectional plan view 504 can provide a top-down view of the composite substrate 205 cross-sectioned along the channels 250 (e.g., through the lower part of the second substrate 265). In the top-down view 504, a cross-sectional line A-A illustrates a horizontal cut along TSVs 245 and channels 250, a cross-section of which is shown in 506 view at cross-section A-A. In the view 506, TSVs 245 of the first substrate 260 and the TSVs 245 of the second substrate 265 are shown vertically or axially aligned with each other, such that they form combined TSVs 295 by physically touching end-to-end (e.g., without intervening pads or other laterally offsetting electrically conductive connectors).

View 508 can correspond to a cross-section along the longitudinal B-B cross-section line at the view 504. Unlike in view 506 in which the TSVs 245 of the first and second substrates 260 and 265 are aligned with each other, at view 508, TSVs 245 of the first and second substrates 260 and 265 are not aligned with each other as they have a different pitch along the B-B line. In such instances, TSV pads 305 can be used in between the TSVs 245 to provide electrical conductivity.

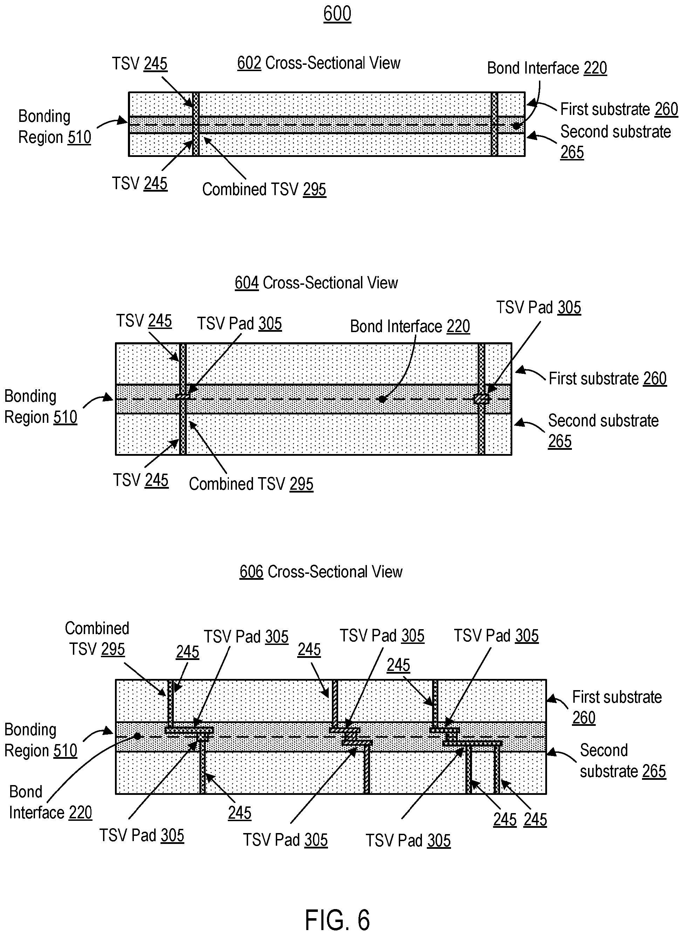

FIG. 6 provides an example system, device or a structure 600 depicted in views 602, 604 and 606. Cross-sectional view 602 can include a first substrate 260 bonded with a second substrate 265 via a bond interface 220. The first and second substrates 260 and 265 can each include TSVs 245 etched perpendicular with respect to the surfaces of the substrates 260 and 265. Bonding interfaces 220 can include bonding regions 510 in which bonding between the substrates 260 and 265 can take place. Bonding region 510 can include TSV pads 305 of various sizes and shapes facilitating electrical connectivity between laterally offset TSVs 245 between the bonded substrates.

At 602 cross-sectional view, a first substrate 260 can be bonded with second substrate 265 via a bond interface 220 at a bonding region 510. TSVs 245 of the first and second substrates 260 and 265 can be vertically or coaxially aligned with each other, thus forming electrical contact and a combined TSV 295 upon bonding without use of any TSV pads 305.

At 604 cross-sectional view, in another configuration the first substrate 260 can be bonded with the second substrate 265 at the same bonding region 510 using a TSV pad 305 for each of the connections of the TSVs 245. As a result, each of combined TSVs 295 is formed by electrically connecting TSVs 245 via TSV pads 305. As shown on the left side of the 604 image, a TSV pad 305 can include an electrically conductive pad formed within or on one of the bonded substrates, such as the first substrate 260. For instance, a TSV pad 305 can be formed adjacent to and within the first substrate 260 and can be smoothed with the surface of the first substrate 260 bonded with the second substrate 265. As shown, for example, in a right-side TSV pad 305, a TSV pad 305 can include two portions, each of which can be formed adjacent to and with each of the substrates 260 and 265 being bonded. Then, upon bonding, the two portions of the TSV pad 305 can come into contact, forming the combined TSV 295.

At 606, combined TSVs 295 can be formed using any number of TSV pads 305 formed within the bonding regions 510 of either the first substrate 260 or the second substrate 265. As shown, for example, on the left side example, a TSV pad 305 can include multiple portions within the first substrate 260 to electrically connect the offset TSVs 245 of the substrates 260 and 265. As shown, for example, on the right side example, a TSV pad 305 can include a plurality of components facilitating a combined TSV 295 being formed by electrically connecting a single TSV 245 from the first substrate 260 with a plurality (e.g., two or more) TSVs 245 of the second substrate 265, via one or more TSV (e.g., bonding) pads 305.

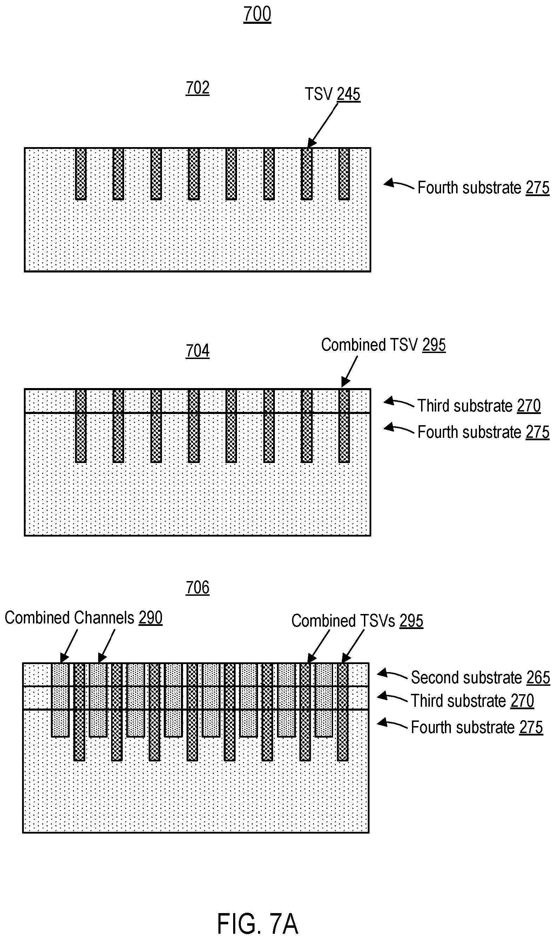

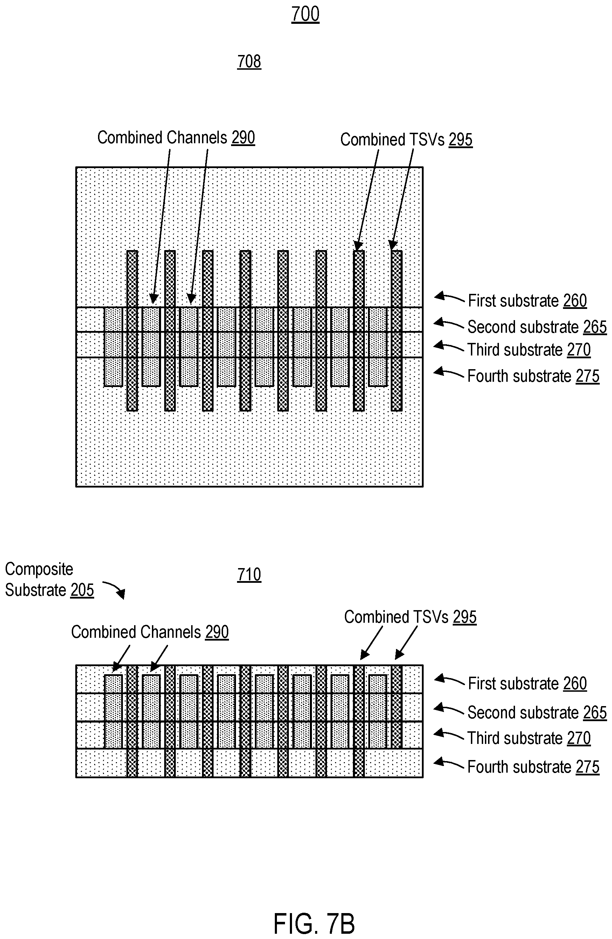

FIG. 7 illustrates an example 700 of a method or process flow for fabricating or forming a device, system or structure, such as example devices, systems or structures shown, described or discussed in FIGs. 1-6. The process flow can include forming or fabricating multiple substrates with fluid channels 250 for convective cooling alongside TSVs 245 for facilitating electrical connectivity. Example fabrication flow 700 can be shown using cross sectional views 702, 704, 706 in FIG. 7A and cross-sectional views 708 and 710 in FIG. 7B.

At view 702, the fabrication process can include depositing silicon-based dielectric and patterning and etching cavities or holes for TSVs 245 to form TSVs 245 inside of the fourth substrate 275. For example, a mask can be used for exposing a surface of the substrate and etching one or more TSV holes or cavities into the fourth substrate 275. The TSV cavity or hole can be etched according to a diameter determined based on a predetermined aspect ratio, such as 10:1, for a given size of the structure. Once etched, the fabrication process can include depositing isolation and seed layers into the cavity, followed by metal material to fill in the cavity and form the TSVs 245. The same processing can be implemented for all of the substrates to be used for the composite substrate 205.

At view 704, the fabrication process can stack or bond the third substrate 270 with the fourth substrate 275, aligning the TSVs 245 of the two substrates with each other to start forming the combined TSVs 295. For instance, when aligning the third substrate 270 with the fourth substrate 275, previously etched and filled TSVs 245 from the third and fourth substrates can be aligned with each other to bring the TSVs 245 in contact with each other to form combined TSVs 295. In some examples, channels 250 can be etched in each of the third and the fourth substrate prior to the bonding of the third and fourth substrates with each other, thereby forming the combined channels 290 upon bonding of the substrates. In some examples, both channels 250 and TSVs 245 can be etched into each individual substrate prior to the substrate being bonded. For instance, TSVs 245 can be etched first, followed by etching of the channels 250 in each of the individual substrates to be used in the stack, and then followed by stacking of the substrates to form a composite substrate 205. In some examples, TSVs 245 can be etched after etching of the channels 250 in each of the individual substrates to be used in the stack, and then followed by stacking of the substrates to form the composite substrate 205. For instance, the third substrate 270 can be bonded to a temporary carrier wafer for stability. The third substrate 270 can be thinned to expose the TSVs 245 formed within the third substrate, after which the polished surface on which the TSVs 245 were exposed through thinning can be bonded with the surface of the fourth substrate 275, aligning the TSVs 245 with each other.

At view 706, a second substrate 265 can be added to the stack of the third substrate 270 and the fourth substrate 275, adding to the combined TSVs 295 being formed. The second substrate 265 can include TSVs 245 previously formed in the individual substrates prior to aligning the substrates and placing the TSVs 245 of the second substrates 265 in contact with the TSVs 245 of the third substrate. This can result in forming a combined TSVs 295 through the second, third and fourth substrates, upon bonding of the second substrate 265 to the surface of the third substrate 270. This process can use the same or similar techniques as those discussed in connection with view 704, adding the second substrate 265 on top of the third substrate 270. Channels 250 can be formed in the substrates individually prior to bonding. In some examples, channels 290 can be formed into the stack with the formed combined TSVs 295 by etching the channels through multiple bonded substrates all at once. For instance, once the second substrate 265 is bonded to the surface of the third substrate 270, trenches or cavities for channels 250 or combined channels 290 can be etched through the second substrate 265, third substrate 270 and the fourth substrate 275, thereby forming combined channels 290 within the cold plate 215 portion of the composite substrate 205.

At view 708 in FIG. 7B, the first substrate 260 can be prepared with the TSVs 245 etched and lined up according to techniques discussed in view 702. The first substrate 260 can be bonded to the second substrate 265, thereby completing the combined TSVs 295 as well as the combined channels 290. The combined channels 290 can be formed within the second substrate 265, third substrate 270 and fourth substrate 275 with the surface of the first substrate 260 providing a top seal of the combined channels 290. The combined TSVs 295 can include aligned and electrically coupled TSVs 245 within each of the four substrates 260-275.

At view 710, the first substrate 260 can be thinned and polished to have its top surface exposing the ends of combined TSVs 295, thereby completing the cold plate 215. The combined TSVs 295 can then be aligned with and coupled to the contacts of the circuit 210 at the die 105, which can be then bonded on the top surface of the first substrate 260, thereby completing the composite substate 205.

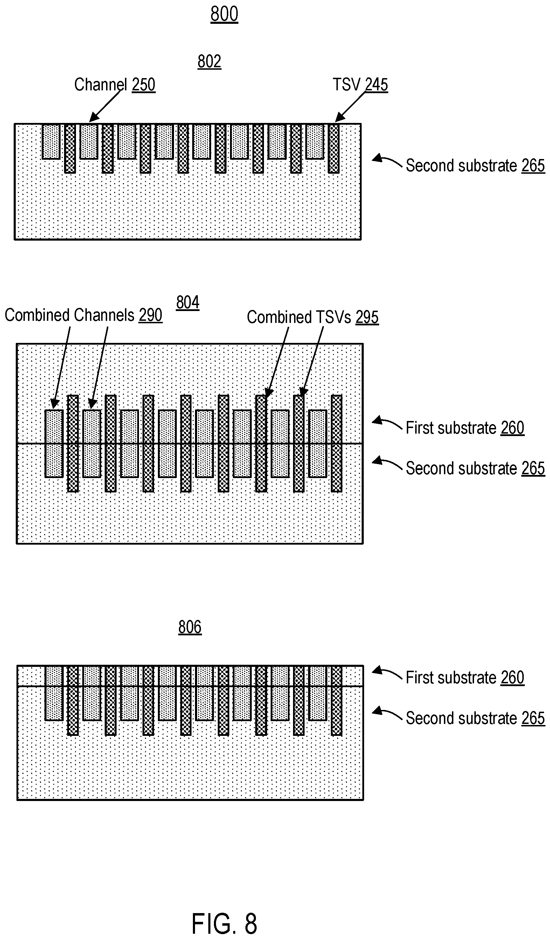

FIG. 8 illustrates an example 800 of a method or process flow for fabricating or forming a device, system or structure, such as example devices, systems or structures shown, described or discussed in FIGs. 1-7B. The process flow can include forming or fabricating multiple substrates with fluid channels 250 for convective cooling alongside TSVs 245 for facilitating electrical connectivity and then aligning and bonding such substrates to complete the composite substrates 205. Example fabrication flow 800 can be shown using cross sectional views 802, 804 and 806.

At view 802, the fabrication process can include depositing silicon-based dielectric and patterning and etching cavities or holes for TSVs 245 to form TSVs 245 inside of the second substrate 265. As with techniques discussed in view 702, masking and patterning can be used to form TSVs 245 within the etched cavities and using metal filling. Similar to techniques discussed in connection with view 706, channels 250 can be patterned and etched into the surface of the second substrate, followed by wafer polishing and thinning to provide a smooth surface for bonding with the first substrate 260.

At view 804, the first substrate 260 can be formed using the same techniques as employed with the second substrate 265, resulting in the two substrates having mirror images of the TSVs 245 and channels 250 to be aligned during the bonding. The first substrate 260 and the second substrate 265 can be bonded having their channels 250 and TSVs 245 aligned and connected, thereby forming combined TSVs 295 and combined channels 290 within both the first and the second substrates 260 and 265.

At view 806, the first substrate can have its open surface thinned and polished to bring expose the combined channels 290 and the combined TSVs 295 for bonding with the die 105 having circuits 210. At this point, the composite substrate 205 and its cold plate 215 can be complete.

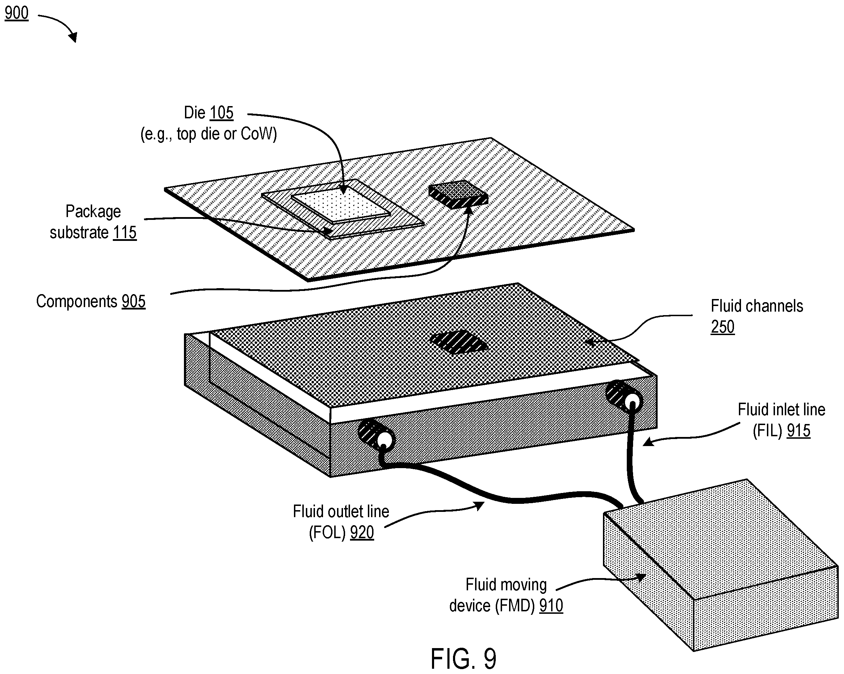

FIG. 9 is an example 900 of a system, structure or device with cold plate with microfluidic channels for backside cooling. A die 105 (e.g., a top die or chip on wafer) can be disposed on a package substrate 115 along with one or more components 905. Components 905 can include other circuits, such as dies 105 with various processors, memories and similar features. Example system 900 can include a fluid moving device 910 for pushing, forcing or moving fluid 255, via fluid inlet line (FIL) 915, through fluid channels 250 beneath the die 105. Once fluid 255 is moved through the channels 250, absorbing the heat from the die 105, fluid 255 can be output from the fluid channels 250, via fluid outlet line (FOL) 920 and brought back to the fluid moving device 910.

Fluid moving device (FMD) 910 can include any combination of hardware and software for moving fluid through channels 250. FMD 910 can include any mechanical or electromechanical system designed to push, move, transport or propel cooling fluids 255 (e.g., gases or liquids) through the one or more fluid channels 250. FMD 910 can be configured to move fluids 255 via fluid outlet lines 920 and fluid inlet lines 915 which can be used to couple the fluid into and out of the fluid channels 250. Fluid moving device 910 can be configured to move the fluid using differential pressure provided by a gravity (e.g., using an elevated fluid tank). FMD 910 can include a micro-pump, which can use mechanisms, such as piezoelectric, electrostatic, or mechanical actuation, to create fluid flow through channels 250. FMD 910 can include a fan or a gas or air blower, such as a fan using spinning blades to generate air movement in electronic systems, to generate airflow through the fluid channels 250 to facilitate gas-based convective cooling. FMD 910 can include a heat exchanger (e.g., a refrigerating device) to cool a fluid moved through FILs 915 and FOLs 920 to reduce the temperature of the fluid 255 and improve heat transfer. FMD 910 can include a fluid inlet line 915 that couples fluid 255 at a first (e.g., lower or cooler) temperature to inlet port 225 and receive fluid 255 from a fluid outlet line 920, via outlet port 230, at a second (e.g., higher or warmer) temperature. FMD 910 can include a water or liquid cooling loop system with a heat exchange system to cool down the fluid 255 received from the cold plate 215 and insert the cooled fluid 255 back into cold plate 215.

Technical solutions can include fluidic channels 250 in the recessed cold plate with components on the interposer of the board and the package substrate with top die 105. The technical solutions can include a hybrid bonded interface at the channel surface, with TSVs on at least one side. For example, the solution can include channels within at least one side of the fluid channel including bonding interface. The solution can include shapes of cooling fins that enable multiple TSVs to pass through. The technical solutions can use TSVs to connect or bond pads at channel hybrid bond interface. The use of TSV outside the microchannel area (outside of the fins) can be implemented, such as to couple to other circuits or substrates.

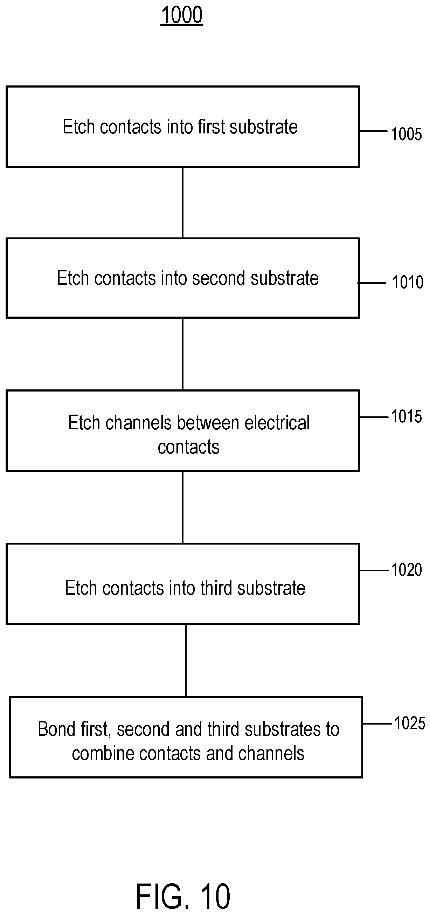

FIG. 10 is an example flow diagram of a method 1000 for providing a cold plate for cooling and electrically integrating a heat generating circuit using combined cooling channels and combined through surface vias (TSVs) formed in a composite substrate. Method 1000 can be implemented or used to produce, form or provide any systems, devices or structures, along with any variations of designs discussed in connection with FIGs. 1-9. Method 1000 can be implemented together with, or in combination with method 700, including any of the operations or acts of the method 700. For instance, method 1000 can include acts 1005 through 1025 for implementing any example features of structures, devices or systems of FIGS. 1-9. At 1005, the method can include etching contacts into a first substrate. At 1010, the method can include etching contacts into a second substrate. At 1015, the method can include etching channels between the electrical contacts. At 1020, the method can include etching contacts into a third substrate. At 1025, the method can include bonding the first, the second and the third substrates to combine the contacts and the channels.

At 1005, the method can include etching contacts into a first substrate. The method can include etching a first plurality of electrical contacts (e.g., through substrate vias or TSVs) such that they are oriented perpendicular with respect to a first surface of a first substrate comprising a circuit. Etching electrical contacts or TSVs into the first substrate can include etching elongate cavities into the surface of the substrate. These cavities can have diameters that can have any shape of top-down cross-section, including, for example, circular, elliptical, square or rectangular. The diameter of the cavities can be on the order of about at least 2, 3, 4, 5, 10, 12 or 15 times smaller than the depth (e.g., height) of the cavity. For instance, for a design of a cavity for a TSV that has a depth to diameter ratio of about 10:1 to 12:1 (e.g., an aspect ratio of 10-12), the cavity can have a diameter of 14um and a depth (e.g., height of the TSV) of about 165-170um. The cavities can be etched perpendicular with respect to the surface of the first substrate on which the cavities are etched (e.g., oriented vertically inward towards the wafer). The cavities can also be etched at various angles, such as at least a 5, 10, 15, 20, 25, 30, 45, 50, 60 or greater than 60-degree angle with respect to surface of the first substrate or the normal axis that is perpendicular to the surface.

To form the electrical contacts (e.g., TSVs) within the cavities of the first substrate, the cavities can be filled with any electrically conductive material, including for example copper or aluminum. The substrate can include any substrate, including a silicon wafer substrate, a glass substrate, a silicon carbide substrate, a gallium or a gallium arsenide substrate, a quartz substrate, a polymer substrate, a ceramic substrate, a fused silica substrate or a flexible substrate. The cavities can include a seed material, such as Tungsten, Titanium, Titanium Nitride, Tantalum or Tantalum Nitride and which can be mixed with the metal material. TSVs can also be formed using a semiconductor material that is sufficiently doped to function as an electrical conductor for the purposes of signal transmissions. TSVs can be formed by filling or depositing electrically conductive material into the cavities. Electrical contacts (e.g., TSVs) can be arranged along any pitch (e.g., of between 40um and 250um distance between each TSV).

The method can include providing a device die comprising the circuit generating heat. The device die can include an interconnect layer that can be disposed on, or adjacent to a surface of the first substrate that includes at least a portion of the surface that is arranged or configured to be in a physical contact with a fluid within the one or more channels formed within a composite substrate. The first substrate can include or be electrically or thermally coupled with a die of any circuit generating heat and creating a rise in temperature. For instance, the first substrate can include or be electrically or thermally coupled with an integrated circuit (IC) that can be formed or manufactured on, or adjacent to, the first surface of the first substrate (e.g., on which TSVs are formed) or on, or adjacent to, a second surface that is opposite to (e.g., on the other side of) the first surface of the first substrate. The circuit can generate heat on the order of milliwatts or watts, which can result in the temperature of the die at about 70-150C, or in some instances more than 150C.

The method can include forming one or more pads for connecting TSVs to TSVs of other substrates (e.g., the second substrate). The pads can be formed by etching flat surfaces, such as circles, rectangles or squares to fill electrically conductive material (e.g., metal) to facilitate a connection between two TSVs of two substrates bonded into a composite substrate. For example, one or more pads can be formed using an electrically conductive material between one or more of the first plurality of electrical contacts of the first substrate and one or more of the second plurality of electrical contacts of the second substrate. The pads can be configured or arranged into the first substrate (or the second substrate, or both) such that one or more of the first plurality of electrical contacts (e.g., TSVs) can be electrically coupled with the one or more of the second plurality of electrical contacts (e.g., TSVs of the second substrate) via the one or more pads.

The method can include forming, within or through the first substrate, an inlet port, or at least a portion of the inlet port, to input a cooling fluid into the one or more channels. The method can include forming, through the first substate, an outlet port, or at least a portion of the outlet port, to output the cooling fluid out of the one or more channels. For example, the inlet port can include one or more cavities etched through the first substrate from any direction (e.g., top surface, bottom surface, side surfaces or any angles) to connect to one or more channels for cooling within the composite substrate (e.g., beneath the first substrate) for conducting a cooling fluid and cooling the circuit.

At 1010, the method can include etching contacts into a second substrate. The method can include etching a second plurality of electrical contacts (e.g., TSVs) perpendicular with respect to a first surface of a second substrate a second substrate. The second plurality of electrical contacts (e.g., TSVs) can be etched into the second substrate using the same or similar methodology as the first plurality of electrical contacts discussed in connection with 1005. The second plurality of electrical contacts can be etched in accordance with an aspect ratio, pitch and TSV diameters that match those of the first plurality of electrical contacts. For example, the second plurality of electrical contacts can have an arrangement in the plane of the first surface of the second substrate so that they are a mirror image of the arrangement of the TSVs in the first surface of the first substrate. For example, when the first surface of the of the first substrate and the first surface of the second substrate are bonded, the resulting bonded first and second substrates can have their combined TSVs formed so that they are electrically conductive from the second surface of the first substrate through the second surface of the second substrate (e.g., via the bonded surface).

The method can include etching a fourth plurality of electrical contacts (e.g., TSVs) through the fourth substrate and perpendicular with respect to a first surface of the fourth substrate. The TSVs in the fourth substrate can be etched using the same or similar techniques as the electrical contacts or TSVs in the first substrate. The electrical contacts of the fourth substrate can also be arranged so that they align with the first plurality of electrical contacts of the first substrate and the second plurality of electrical contacts of the second substrate, so that upon bonding, the combined TSVs can run through the first, second and fourth substrates in line or without breaks in electrical conductivity from the start of each of the first TSVs to the end of each of the fourth TSVs.

The method can include forming one or more pads using an electrically conductive material between one or more of the first plurality of electrical contacts of the first substrate and one or more of the second plurality of electrical contacts of the second substrate. The one or more of the first plurality of electrical contacts can be electrically coupled with the one or more of the second plurality of electrical contacts via the one or more pads. The method can include forming, within or through the second substrate, an inlet port, or at least a portion of the inlet port, to input a cooling fluid into the one or more channels. The method can include forming, through the second substate, an outlet port, or at least a portion of the outlet port, to output the cooling fluid out of the one or more channels.

At 1015, the method can include etching one or more channels between the electrical contacts. The method can include etching one or more channels between the second plurality of electrical contacts and through the second substrate. The one or more channels can be oriented perpendicular to the second plurality of electrical contacts. For example, the channels can be oriented alongside fins that can include portions of the first substrate or the second substrate through which TSVs are formed. The fins can form the sidewalls of the one or more channels.

The method can include etching a single channel between the perpendicularly or vertically oriented TSVs. The channel can be disposed beneath the circuit generating heat. The channel can be oriented perpendicular to the TSVs, so that it can run through the thickness of the composite substrate formed by bonding any combination of at least the first, the second and the third substrates. The channel can have a cross-section of any shape, such as a rectangle, square, circle or an oval. The channel can have any pattern, such as a straight line, a curved line, a zigzag, a spiral or any other shape through which cooling fluid can be moved.

The method can include etching a second one or more channels between the fourth plurality of electrical contacts and through the fourth substrate. The second one or more channels can be oriented perpendicular to the fourth plurality of electrical contacts. The second one or more channels can be bonded with and combined with the first one or more channels to form a combined channel having a combined (e.g., larger) cross-section and allowing for an improved fluid throughput and heat dissipation capacity via the combined one or more channels.

The method can include forming a plurality of fins using at least the second substrate. The plurality of fins can include substate materials (e.g., materials of the first, the second, the third and the fourth substrate). The plurality of fins can include at least a first fin of the plurality of fins separated from at least a second fin of the plurality of fins by a channel of the one or more channels (e.g., the first channel, the second channel or the combined channel). Each of the first fin and the second fin can form a part of a sidewall of the channel and can include at least one electrical contact of the second plurality of electrical contacts traversing a height of each respective fin.

At 1020, the method can include etching contacts into a third substrate. The method can include etching a third plurality of electrical contacts (e.g., third plurality of TSVs) perpendicular to a first surface of a third substrate. The third plurality of electrical contacts (e.g., TSVs) can be etched into the third substrate using the same or similar methodology as the first plurality of electrical contacts discussed in connection with act 1005 or the second plurality of electrical contacts (e.g., second plurality of TSVs) discussed in connection with act 1010. The third plurality of electrical contacts can be etched in accordance with an aspect ratio, pitch and TSV diameters that match those of the first or the second plurality of electrical contacts. For example, the third plurality of electrical contacts can have an arrangement in the plane of the first surface of the third substrate so that they are a mirror image of the arrangement of the TSVs in the first surface of the first substrate or the first surface of the second substrate. For example, when the first surface of the of the third substrate and the second surface of the second substrate are bonded, the resulting composite substrate (including at least the first, second and third substrates) can have their combined TSVs formed so that they are electrically conductive from the second surface of the first substrate through the second surface of the third substrate (e.g., via the bonded surface) without any break in electrical conductivity.

At 1025, the method can include bonding the first, the second and the third substrates to combine the contacts and the channels. The method can include bonding the first substrate with the second substrate and bonding the second substrate with the third substrate to form at least a portion of the combined substrate. The method can include bonding the first substrate with the second substrate and the third substrate to electrically couple the circuit generating heat with the third plurality of electrical contacts (e.g., TSVs in the third substrate) via the first plurality of electrical contacts (e.g., TSVs in the first substrate) and the second plurality of electrical contacts (e.g., TSVs in the second substrate). The method can include bonding the first, the second and the third substrates to form, seal or enclose the one or more channels (e.g., combined channels etched in at least two substrates of the first, second, third and fourth substrates) so that the channels traverse through at least the second substrate by the first substrate. The combined channel can traverse also at least a portion of the third substrate or at least a portion of the first substrate, or both at least parts of the first and the third substrates, along with the second. The one or more channels can dissipate the heat generated by the circuit via the one or more fins and to the fluid moved through the one or more channels.

The method can include forming a first bond between the first surface of the first substrate and the first surface of the second substrate to couple the first plurality of electrical contacts with the second plurality of electrical contacts. The method can include forming a second bond between the first surface of the third substrate and a second surface of the second substrate opposite of the first surface of the second substrate to couple the second plurality of electrical contacts with the third plurality of electrical contacts. The method can include configuring the one or more channels to contain a cooling fluid moved through the one or more channels to dissipate the heat generated by the circuit away from the circuit. The one or more channels can be configured to place the cooling fluid in a physical contact with at least a portion of the first surface of the first substrate.

The method can include bonding the fourth substrate with the second substrate to couple the second one or more channels of the fourth substrate and the one or more channels of the second substrate to form a combined one or more channels. The combined one or more channels can traverse through at least the second substrate and the fourth substrate that can be bonded with the second substrate. For instance, the fourth substrate can be bonded between the second substrate and the third substrate thereby sharing the one or more combined channels with the second substrate. The combined one or more channels can include a cross section whose height includes a sum of a first height of the one or more channels in the second substrate and a second height of the second one or more channels in the fourth substrate. The cross section can have a width corresponding to at least one of a first width of the one or more channels or a second width of the second one or more channels. The method can include configuring the circuit to receive electrical power for operating the circuit via the third plurality of electrical contacts coupled with the circuit via the first plurality of electrical contacts and the second plurality of electrical contacts.

When an element is referred to herein as being "connected" or "coupled" to another element, it is to be understood that the elements can be directly connected or coupled the other element, or have intervening elements present between the connected or coupled elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being in "thermal contact" with another element, it is to be understood that the elements can be in direct or physical contact or coupling with the other element, or can have intervening materials, layers, objects or elements present between the two elements. In contrast, when an element is referred to as being in "direct thermal contact" with another element, it should be understood that no intervening elements are present in the "direct" connection between the elements. However, the existence of a direct thermal contact does not exclude other thermal contacts, in which intervening elements may be present.

When an element is referred to herein as being "disposed" beneath or above a particular element, it is to be understood that the elements can be directly located or positioned above or below the other element, or have intervening elements present between the two elements. In contrast, when an element is referred to as being "directly disposed" on or below another element, it should be understood that no intervening elements are present in the "direct" disposition between the elements. However, the existence of a direct disposition does not exclude other disposition, in which intervening elements may be present.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first substrate and a second substrate) temporally or according to a sequence, although in some cases, these entities can include such a relationship. Nor do these terms limit the number of possible entities (e.g., delay circuit, filter, peak detector) that can operate within a system or environment. It should be understood that the systems described above can provide multiple ones of any or each of those components and these components can be provided on either a standalone structure or device or, in some embodiments, on multiple structures or devices in a distributed system.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. A system, comprising:
a first substrate (260) comprising a circuit (210) coupled with a first plurality of electrical contacts etched perpendicular with respect to a first surface of the first substrate (260);
a second substrate (265) comprising:
a second plurality of electrical contacts etched through the second substrate (265) and perpendicular with respect to a first surface of the second substrate (265); and
one or more channels (250) etched between the second plurality of electrical contacts and through the second substrate (265) and oriented perpendicular to the second plurality of electrical contacts; and
a third substrate (270) comprising a third plurality of electrical contacts etched perpendicular to a first surface of the third substrate (270), wherein the one or more channels (250) traverse through at least the second substrate (265) and are enclosed by the first substrate (260), the second substrate (265) and the third substrate (270); and
wherein the circuit (210) is electrically coupled with the third plurality of electrical contacts via the first plurality of electrical contacts and the second plurality of electrical contacts and the channel (250) is configured to dissipate heat generated by the circuit (210).

2. The system of claim 1, comprising:
A first bond between the first surface of the first substrate (260) and the first surface of the second substrate (265) to couple the first plurality of electrical contacts with the second plurality of electrical contacts; and
a second bond between the first surface of the third substrate (270) and a second surface of the second substrate (265) opposite of the first surface of the second substrate (265) to couple the second plurality of electrical contacts with the third plurality of electrical contacts.

3. The system of claim 1 or 2, wherein the one or more channels (250) is configured to contain a cooling fluid moved through the one or more channels (250) to dissipate the heat generated by the circuit (210) away from the circuit (210).

4. The system of any of claims 1 to 3, wherein the one or more channels (250) is configured to place a cooling fluid contained within the one or more channels (250) in a physical contact with at least a portion of the first surface of the first substrate (260).

5. The system of any of claims 1 to 4, comprising:
a fourth substrate (275);
a fourth plurality of electrical contacts etched through the fourth substrate (275) and perpendicular with respect to a first surface of the fourth substrate (275); and
a second one or more channels (250) etched between the fourth plurality of electrical contacts and through the fourth substrate (275) and oriented perpendicular to the fourth plurality of electrical contacts, wherein the fourth substrate (275) is bonded with the second substrate (265) to couple the second one or more channels (250) of the fourth substrate (275) and the one or more channels (250) of the second substrate (265) to form a combined one or more channels (290), the combined one or more channels (290) traversing through at least the second substrate (265) and the fourth substrate (275).

6. The system of claim 5, wherein the combined one or more channels (290) includes a cross section whose height includes a sum of a first height of the one or more channels (250) and a second height of the second one or more channels (250), the cross section having a width corresponding to at least one of a first width of the one or more channels (250) or a second width of the second one or more channels (250).

7. The system of any of claims 1 to 6, comprising:
a plurality of fins (240) formed using at least the second substrate (265), the plurality of fins (240) comprising at least a first fin (240) of the plurality of fins (240) separated from at least a second fin (240) of the plurality of fins (240) by a channel (250) of the one or more channels (250), each of the first fin (240) and the second fin (240) forming a part of a sidewall of the channel (250) and comprising at least one electrical contact of the second plurality of electrical contacts traversing a height of each respective fin (240).

8. The system of any of claims 1 to 7, comprising:
a device die (105) comprising the circuit (210), wherein the device die (105) includes an interconnect layer disposed on, or adjacent to, a second surface of the first substrate (260).

9. The system of any of claims 1 to 8, comprising:
the device die (105) comprising the circuit (210) having an interconnect layer disposed on, or adjacent to, the first surface of the first substrate (260), wherein at least a portion of the first surface is configured to be in a physical contact with a fluid within the one or more channels (250).

10. The system of any of claims 1 to 9, comprising at least one of the following features:
wherein first substrate (260) is bonded with the second substrate (265) to axially align one or
more of the first plurality of electrical contacts with one or more of the second plurality of electrical contacts;
comprising:
one or more pads comprising an electrically conductive material formed between one or more of the first plurality of electrical contacts of the first substrate (260) and one or more of the second plurality of electrical contacts of the second substrate (265), the one or more of the first plurality of electrical contacts electrically coupled with the one or more of the second plurality of electrical contacts via the one or more pads;
wherein the circuit (210) is configured to receive electrical power for operating the circuit (210) via the third plurality of electrical contacts coupled with the circuit (210) via the first plurality of electrical contacts and the second plurality of electrical contacts;
comprising:
an inlet port to input a cooling fluid into the one or more channels (250); and
an outlet port to output the cooling fluid out of the one or more channels (250).

11. A method, comprising:
etching a first plurality of electrical contacts perpendicular with respect to a first surface of a first substrate (260) comprising a circuit (210);
etching a second plurality of electrical contacts perpendicular with respect to a first surface of a second substrate (265) a second substrate (265);
etching one or more channels (250) between the second plurality of electrical contacts and through the second substrate (265), the one or more channels (250) oriented perpendicular to the second plurality of electrical contacts; and
etching a third plurality of electrical contacts perpendicular to a first surface of a third substrate (270);
bonding the first substrate (260), the second substrate (265) and the third substrate to electrically couple the circuit (210) with the third plurality of electrical contacts via the first plurality of electrical contacts and the second plurality of electrical contacts and to enclose the one or more channels (250) traversing through at least the second substrate (265) by the first substrate (260), the second substrate (265) and the third substrate (270) to dissipate the heat generated by the circuit (210).

12. The method of claim 11, comprising:
forming a first bond between the first surface of the first substrate (260) and the first surface of the second substrate (265) to couple the first plurality of electrical contacts with the second plurality of electrical contacts;
forming a second bond between the first surface of the third substrate (270) and a second surface of the second substrate (265) opposite of the first surface of the second substrate (265) to couple the second plurality of electrical contacts with the third plurality of electrical contacts; and
configuring the one or more channels (250) to contain a cooling fluid moved through the one or more channels (250) to dissipate the heat generated by the circuit (210) away from the circuit (210), wherein the one or more channels (250) is configured to place the cooling fluid in a physical contact with at least a portion of the first surface of the first substrate (260).

13. The method of claim 11 or 12, comprising:
etching a fourth plurality of electrical contacts through the fourth substrate (275) and perpendicular with respect to a first surface of the fourth substrate (275); and
etching a second one or more channels (250) between the fourth plurality of electrical contacts and through the fourth substrate (275), the second one or more channels (250) oriented perpendicular to the fourth plurality of electrical contacts;
bonding the fourth substrate (275) with the second substrate (265) to couple the second one or more channels (250) of the fourth substrate (275) and the one or more channels (250) of the second substrate (265) to form a combined one or more channels (290), the combined one or more channels (290) traversing through at least the second substrate (265) and the fourth substrate (275), wherein the combined one or more channels (290) includes a cross section whose height includes a sum of a first height of the one or more channels (250) and a second height of the second one or more channels (250), the cross section having a width corresponding to at least one of a first width of the one or more channels (250) or a second width of the second one or more channels (250).

14. The method of any of claims 11 to 13, comprising at least one of the following features:
comprising:
forming a plurality of fins (240) using at least the second substrate (265), the plurality of fins (240) comprising at least a first fin (240) of the plurality of fins (240) separated from at least a second fin (240) of the plurality of fins (240) by a channel (250) of the one or more channels (250), each of the first fin (240) and the second fin (240) forming a part of a sidewall of the channel (250) and comprising at least one electrical contact of the second plurality of electrical contacts traversing a height of each respective fin (240);
comprising:
providing a device die (105) comprising the circuit (210), wherein the device die (105) includes an interconnect layer disposed on, or adjacent to, at least one surface of the first substrate (260), the at least one surface comprises at least a portion of the at least one surface configured to be in a physical contact with a fluid within the one or more channels (250); and
forming one or more pads using an electrically conductive material between one or more of the first plurality of electrical contacts of the first substrate (260) and one or more of the second plurality of electrical contacts of the second substrate (265), the one or more of the first plurality of electrical contacts electrically coupled with the one or more of the second plurality of electrical contacts via the one or more pads;
comprising:
forming an inlet port to input a cooling fluid into the one or more channels (250);
forming an outlet port to output the cooling fluid out of the one or more channels (250).
configuring the circuit (210) to receive electrical power for operating the circuit (210) via the third plurality of electrical contacts coupled with the circuit (210) via the first plurality of electrical contacts and the second plurality of electrical contacts.

15. A structure having a composite substrate for cooling a circuit (210) using one or more channels (250), comprising:
a composite substrate, comprising:
a first substrate (260) comprising a circuit (210) coupled with a first plurality of electrical contacts etched perpendicular with respect to a first surface of the first substrate (260);
a second substrate (265) comprising:
a second plurality of electrical contacts etched through the second substrate (265) and perpendicular with respect to a first surface of the second substrate (265); and
one or more channels (250) etched between the second plurality of electrical contacts and through the second substrate (265) and oriented perpendicular to the second plurality of electrical contacts; and
a third substrate (270) comprising a third plurality of electrical contacts etched perpendicular to a first surface of the third substrate (270); and
wherein the composite substrate includes a first bond between the first substrate (260) and the second substrate (265) and a second bond between the second substrate (265) and the third substrate (270) to electrically couple the circuit (210) with the third plurality of electrical contacts via the first plurality of electrical contacts and the second plurality of electrical contacts and to enclose the one or more channels (250) traversing through at least the second substrate (265) by the first substrate (260), the second substrate (265) and the third substrate (270), the one or more channels (250) configured to dissipate the heat generated by the circuit (210).
